(19) Europäisches Patentamt

European Patent Office

Office européen des brevets

(11) EP 4 760 769 A2

(12) EUROPEAN PATENT APPLICATION

(43) Date of publication:
17.06.2026 Bulletin 2026/25

(21) Application number: 25221753.4

(22) Date of filing: 09.12.2025

(51) International Patent Classification (IPC):
H01J 37/153 (2006.01)        H01J 37/12 (2006.01)

(52) Cooperative Patent Classification (CPC):
H01J 37/153; H01J 37/12; H01J 2237/1534;
H01J 2237/31749

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 10.12.2024 US 202463730334 P

(71) Applicant: FEI Company
Hillsboro, OR 97124 (US)

(72) Inventors:
• GLEDHILL, Galen
  Portland (US)
• HENSTRA, Alexander
  Utrecht (NL)

(74) Representative: Boult Wade Tennant LLP
Salisbury Square House
8 Salisbury Square
London EC4Y 8AP (GB)

(54) FOCUSED ION BEAM SYSTEMS INCLUDING MULTIPOLE ELEMENTS AND DECELERATION ELEMENTS

(57) Charged particle microscope systems including multipole optics are described. An ion-optical column can include an aberration correction system. The aberration correction system can be disposed on an axis and can include a multipole condenser. The multipole condenser can include one or more condenser quadrupole-generating elements. The aberration correction system can also include a multipole objective. The multipole objective can include a plurality of objective multipole elements. The ion-optical column can include an objective lens assembly, disposed on the axis. The ion-optical column can also include a deceleration element. The deceleration element can be disposed on the axis between at least a portion of the aberration correction system and a sample position external to the charged particle optical column.

FIG. 10

EP 4 760 769 A2

## Description

### FIELD

The present disclosure relates generally to charged particle microscope systems, and specifically to charged particle beam systems including optics for correcting spherical and/or chromatic aberration in a charged particle beam.

### BACKGROUND

Focused ion beam systems include electromagnetic round lenses to direct ion beams toward a specimen. Such round lenses, however, generate positive spherical and chromatic aberration coefficients that restrict higher opening angles and inhibit resolution and probe current.

### SUMMARY

In a representative example, an ion-optical column, includes an aberration correction system. The aberration correction system can be disposed on an axis and can include a multipole condenser. The multipole condenser can include one or more condenser quadrupole-generating elements. The aberration correction system can also include a multipole objective. The multipole objective can include a plurality of objective multipole elements. The ion-optical column can include an objective lens assembly, disposed on the axis. The ion-optical column can also include a deceleration element. The deceleration element can be disposed on the axis between at least a portion of the aberration correction system and a sample position external to the charged particle optical column.

In some embodiments, the multipole objective includes at least three quadrupole-generating elements. The multipole objective can also include at least three octupole-generating elements. The octupole-generating elements of the multipole objective can be configured to at least partially correct a spherical aberration of the charged particle beam.

In some embodiments, the deceleration element includes a plurality of electrodes. The plurality of electrodes can be mutually isolated and disposed on the axis. The electrodes can be annular. The electrodes can be substantially centered about the axis. The electrodes can be mechanically coupled via insulating material.

In some embodiments, the deceleration element substantially overlaps with a position on the axis of a first element of the objective lens assembly. The ion-optical column can further include bias circuitry. At least a portion of the aberration correction system can be electrically coupled with the bias circuitry. The portion of the aberration correction system can be configured to operate at a bias voltage supplied by the bias circuitry. The portion of the aberration correction system can include a conducting element disposed about the axis and terminating at a first end proximal to the deceleration element. The conducting element can be operably coupled with the bias circuitry. The conducting element can define an inner volume, and wherein at least the portion of the aberration correction system is disposed in the inner volume. The deceleration element can include an ion-transfer lens.

In some embodiments, the ion-optical column further includes a chromatic aberration corrector disposed on the axis, between the multipole condenser and the multipole objective. The chromatic aberration corrector can include a plurality of electrostatic elements configured to deflect an incident charged particle beam along an a-shaped path. The plurality of electrostatic elements can include a plurality of electrostatic multipole elements configured to at least partially correct an axial chromatic aberration of the charged particle beam. The chromatic aberration corrector can also include a deflector assembly comprising a corrector electrostatic prism and the plurality of electrostatic multipole elements. The deflector assembly can be configured to deflect the charged particle beam along a deflector optical axis.

The corrector electrostatic prism can include a corrector prism body with a first corrector prism electrode and a second corrector prism electrode positioned radially exteriorly of the first corrector prism electrode. The first corrector prism electrode and the second corrector prism electrode can define an electrode gap therebetween. The deflector assembly can be configured to at least partially correct an axial chromatic aberration in the charged particle beam with two or more hexapole fields generated within the corrector electrostatic prism.

The aberration correction system can include a first objective multipole element. The first objective multipole element can be configured to generate a first objective multipole field comprising a first objective quadrupole field component and a first objective octupole field component. The aberration correction system can include a second objective multipole element. The second objective multipole element can be positioned downstream of the first objective multipole element. The second objective multipole element can be configured to generate a second objective multipole field comprising a second objective octupole field component. The aberration correction system can include a third objective multipole element. The third objective multipole element can be positioned downstream of the second objective multipole element. The third objective multipole element can be configured to generate a third objective multipole field including a third objective quadrupole field component and a third objective octupole field component. The ion-optical column can further include a fourth objective multipole element. The fourth objective multipole element can be positioned downstream of the third objective multipole element and configured to generate fourth objective multipole field comprising a fourth objective quadrupole field component, wherein the fourth objective multipole element comprises eight electrodes.

In another representative example, a charged particle beam system can include a source of ions, the ion-optical column of the preceding example in one or more embodiments, and a sample holder defining a sample position. The components of the charged particle beam system can be disposed along the axis. The source of ions is oriented to direct a beam of ions toward the sample position, via the ion-optical column. The charged particle beam system can include control circuitry and one or more machine readable storage media, coupled with the control circuitry and storing instructions that, when executed by a machine, cause the machine to perform operations comprising

The terms and expressions which have been employed are used as terms of description and not of limitation, and there is no intention in the use of such terms and expressions of excluding any equivalents of the features shown and described or portions thereof, but it is recognized that various modifications are possible within the scope of the claimed subject matter. Thus, it should be understood that although the present claimed subject matter has been specifically disclosed by embodiments and optional features, modification and variation of the concepts herein disclosed can be resorted to by those skilled in the art, and that such modifications and variations are considered to be within the scope of this disclosure as defined by the appended claims.

## BRIEF DESCRIPTION OF THE DRAWINGS

FIG. 1 is a schematic side elevation view of a charged particle microscope system according to an example.

FIG. 2 is a front elevation view of an electrostatic hexapole-generating element according to an example.

FIG. 3 is a schematic side elevation view of an aberration correction system according to an example.

FIG. 4 is a schematic side elevation view of an aberration correction system according to another example.

FIG. 5 is a schematic side elevation view of a charged particle microscope system according to an example.

FIG. 6 is a front elevation view of an electrostatic multipole element with four electrodes according to an example.

FIG. 7 is a front elevation view of an electrostatic multipole element with eight electrodes according to an example.

FIG. 8 is a schematic representation of another charged particle microscope system and of the fundamental rays of a charged particle beam traversing the charged particle microscope system, in which third order aberrations are corrected and the charged particle microscope system operates with a first magnification, according to an example.

FIG. 9 is a schematic diagram of a charged particle acceleration system, in accordance with embodiments of the present disclosure.

FIG. 10 is a schematic diagram of an aberration correction system including a deceleration element as part of a physical acceleration system, in accordance with embodiments of the present disclosure.

FIG. 11 is a schematic diagram of an aberration correction system including a deceleration element as part of a virtual acceleration system, in accordance with embodiments of the present disclosure.

FIG. 12 is a schematic diagram of an aberration correction system including a deceleration element disposed between the aberration correction system and an objective lens assembly, in accordance with embodiments of the present disclosure.

FIG. 13A is a ray diagram of an aberration correction system including a deceleration element disposed before a multipole objective, in accordance with embodiments of the present disclosure.

FIG. 13B is a ray diagram of an aberration correction system including a deceleration element disposed after a multipole objective, in accordance with embodiments of the present disclosure.

FIG. 13C is a ray diagram of an aberration correction system including a deceleration element disposed after a chromatic aberration ($C_c$) corrector optic and before a multipole objective, in accordance with embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

## DETAILED DESCRIPTION

Charged particle beam systems such as scanning electron microscopes and focused ion beam microscopes are widely used in the semiconductor and nanotechnology industries for imaging, manufacturing, and/or modifying microscopic structures, such as by irradiating such structures with a charged particle beam (e.g., an electron beam or an ion beam). Such beam systems commonly utilize electromagnetic lenses to converge, deflect, and focus the charged particle beam onto the sample. As with optical systems, charged particle beam systems introduce axial aberrations that increase the size of the charged particle beam spot on the sample, thereby limiting the spatial resolution of the system.

In particular, the focusing lens positioned closest to the sample, also known as the objective lens, contributes the most to the axial aberrations of an aperture, such as the chromatic and spherical aberrations (denoted Cc and Cs, respectively). As described in the publication by O. Scherzer, "Über einige Fehler von Elektronenlinsen," Z. Physik 101, 1936, electromagnetic round lenses always generate a positive chromatic and spherical aberration coefficient so that a round lens cannot fully compensate for the aberration of another round lens.

Moreover, in another publication of the same author (O. Scherzer, "Sphärische und chromatische Korrektur von Elektronenlinsen," Optik 2, 1947, p. 114), it was shown that aberrations of round electromagnetic lenses can be compensated by the negative aberrations generated by multipoles. A multipole element comprises N poles (e.g., electrodes) and is configured for generating electrostatic or magnetic multipole fields of $\leq$ N-fold rotational symmetry. Thus, a multipole element can generate (a combination of) dipole fields, hexapole fields, octupole fields, and so on.

An example of a current solution for correcting the chromatic and spherical aberration of electron lenses has been recently proposed in "Magnetic Cc/Cs-corrector compensating for the chromatic aberration and the spherical aberration of electron lenses" (H. Rose, A. Nejati, H. Müller, Ultramicroscopy 203, 2019, p. 139-144, referred to hereinafter as Rose et al. 2019) in which a purely magnetic corrector is introduced in detail. In particular, the authors describe a curved axis corrector that comprises magnetic quadrupole and hexapole-generating elements arranged in an omega-shaped design.

As mentioned in Rose et al. 2019, the quadrupoles are configured for focusing and forming the beam, while the hexapoles are tuned in a manner that counterbalances the positive chromatic aberration of the electrical-optical system. Because the first-order rays are very astigmatic inside the corrector, one can add octupoles in appropriate places in order to correct for the spherical aberration as well. This fully magnetic imaging corrector is intended for implementation in electron microscopes such as a Transmission Electron Microscope (TEM) and is particularly configured for correcting the chromatic aberration and spherical aberration for beam energies up to 1.2 MeV. However, the Cc/Cs correctors of Rose et al. 2019 utilize magnetic fields alone, and are therefore impractical for ions, since ions being heavier than electrons, are less susceptible to magnetic fields.

Alternatively, one could use purely electrostatic Cc/Cs correctors for both electron and ion beams with a straight axis, as described for example in U.S. Patent Application Publication No. 2004/0051985, but such correctors are complex and the pass beam energy is quite low (up to 8 kV), so ion-ion interactions are problematic.

Very recently, the company CEOS/JEOL developed an electrostatic corrector suitable for beam energies up to 30 keV (https://www.ceos-gmbh.de/en/research/electrostat). However, the proposed corrector leads to major disadvantages, such as the generation of large higher order aberrations, and high sensitivity to alignment errors due to very strong focusing power of the Cc-correcting elements. Thus, the proposed corrector by CEOS/JEOL is suited only for ion optics.

Examples of the disclosed technology seek to alleviate and/or overcome the shortcomings and disadvantages of existing aberration correction systems. More particularly, examples herein can include improved systems for correcting axial aberrations of a charged particle beam system.

Examples of the disclosed technology can also include a corrector of axial chromatic and/or spherical aberrations, such as a purely electrostatic corrector compensating the chromatic and/or spherical aberrations of a charged particle beam system.

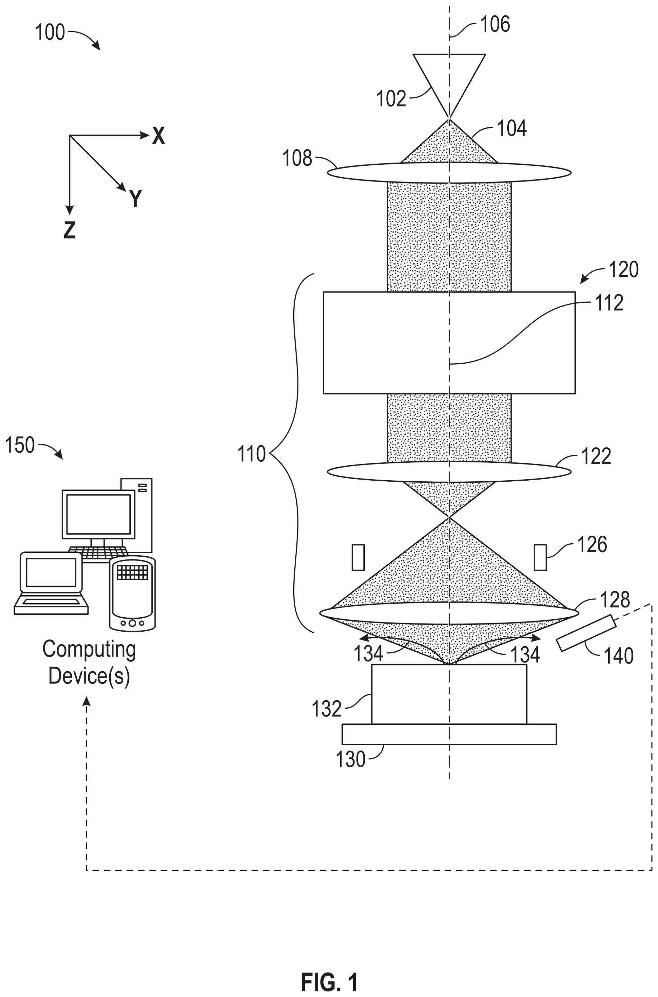

FIG. 1 illustrates an example of a charged particle microscope system 100 that can include and/or utilize aberration correction systems as disclosed herein. In the example of FIG. 1, the charged particle microscope system 100 is configured to direct or focus a charged particle beam 104 upon a sample 132 for inspection and/or analysis of one or more properties of the sample 132. The charged particle microscope system 100 can include and/or be any of a variety of systems, such as an electron microscope (EM) setup or electron lithography setup configured to irradiate and/or otherwise impinge the sample 132 with the charged particle beam 104.

In various examples, the charged particle microscope system 100 may include and/or be one or more different types of focused ion beam and/or other charged particle microscopes, examples of which include a scanning electron microscope (SEM), a scanning transmission electron microscope (STEM), a transmission electron microscope (TEM), a charged particle microscope (CPM), dual beam microscopy system, etc. Additionally, in some examples, a TEM is capable of operating as a STEM as well. In the example of FIG. 1, the charged particle microscope system 100 is a SEM or FIB system.

As shown in FIG. 1, the example charged particle microscope system 100 includes a charged particle source 102 (e.g., a thermal electron source, Schottky-emission source, field emission source, a liquid metal ion source, a plasma ion source, etc.) that emits the charged particle beam 104 along an emission axis 106 and toward condenser optics 108. The condenser optics 108 can include an electrostatic gun lens, an accelerator, and/or one or more condenser lenses. The emission axis 106 can be a central axis that runs along the length of the example charged particle microscope system 100 from the charged particle source 102 and through the sample 132. Additionally or alternatively, the emission axis 106 can refer to and/or include a portion of the path followed by the charged particle beam 104 that extends proximate the charged particle source 102.

The accelerator lens of the condenser optics 108 accelerates/decelerates, focuses, and/or directs the charged particle beam 104 towards a focusing column 110. As used herein, the focusing column 110 additionally or alternatively may be referred to as an optical column 110. The focusing column 110 focuses the charged particle beam 104 so that it is incident on sample 132. Additionally, the focusing column 110 corrects and/or tunes aberrations (e.g., geometric aberrations, chromatic aberrations) of the charged particle beam 104.

As shown in FIG. 1, the focusing column 110 can be described as including, encompassing, and/or defining an optical column axis 112 along which the charged particle beam 104 travels through at least a portion of the focusing column 110. In some examples, the emission axis 106 may be described as including the optical column axis 112. While FIG. 1 illustrates the optical column axis 112 as being straight for simplicity, this is not required, and it is within the scope of the present disclosure that the optical column axis 112 may be curved.

As shown in FIG. 1, the focusing column 110 can include an aberration correction system 120 as described in more detail below. The focusing column 110 additionally can include a transfer lens 122 and an objective lens 128.

The objective lens 128 is an optical element that focuses the charged particle beam 104 to a point (e.g., a well-localized spot) on the sample 132. The objective lens 128 can generate a positive Cs. The objective lens 128 can include and/or be any of a variety of focusing elements, examples of which include a single-polepiece lens, a magnetic electrostatic compound lens, electrostatic objective lens, or another type of objective lens.

FIG. 1 further illustrates the charged particle microscope system 100 as including a sample holder 130 that holds the sample 132 and a detector 140 that is configured to detect charged particles 134 that are discharged from the sample 132 as a result of the charged particle beam 104 being incident upon the sample 132. In addition, the charged particle microscope system 100 is illustrated as including astigmatism correction and scan coils 126 for directing the charged particle beam 104 to scan the surface of the sample 132. For example, the scan coils 126 can be configured to selectively shift the direction of the charged particle beam 104 so that the charged particle beam 104 can be scanned (e.g., raster scanned) across an area of the surface of the sample 132 to be probed.

As shown in FIG. 1, the charged particle microscope system 100 additionally can include one or more computing devices 150 programmed and/or configured to control operation of one or more aspects of the charged particle microscope system 100. As an example, the computing device(s) 150 can be programmed and/or configured to direct the charged particle beam 104 to a desired location upon the sample 132, such as by translating the sample holder 130 and/or operating the scan coils 126. Additionally or alternatively, the computing device(s) 150 can be programmed and/or configured to receive a signal from the detector 140 to characterize the sample 132.

Those skilled in the art will appreciate that the computing devices 150 depicted in FIG. 1 are merely illustrative and are not intended to limit the scope of the present disclosure. The computing device(s) 150 can include and/or be any suitable combination of hardware or software that can perform the indicated functions, including computers, network devices, Internet appliances, PDAs, wireless phones, controllers, oscilloscopes, amplifiers, etc. The computing device(s) 150 also can be connected to other devices that are not illustrated (e.g., via wired and/or wireless communication connections), or may operate as a stand-alone system.

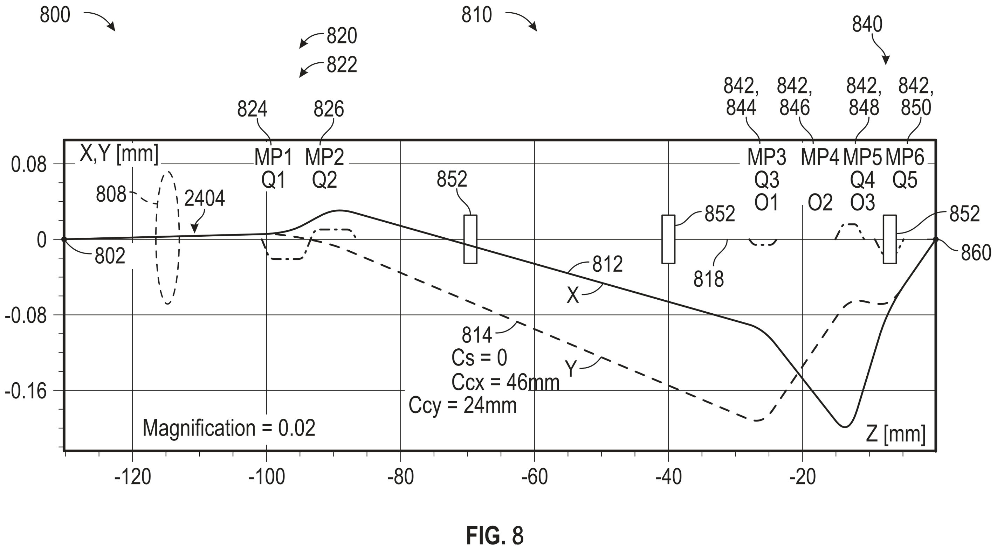

As discussed above, one or more components of a charged particle beam system such as the objective lens 128 of the charged particle microscope system 100 can generate chromatic and spherical axial aberrations that limit the precision with which a charged particle beam can be focused upon a sample. To clarify the manner in which correction systems such as the aberration correction system 120 can operate to correct for such aberrations, the following discussion considers the origins and forms of such aberrations. While the following discussion is presented primarily in the context of electron beams, it is to be understood that the principles can apply to electron beams and ion beams, e.g., by introducing a sign change in some equations. In the following discussion, calculations are performed in a non-relativistic approximation, which is suitable for ion beams and for electron beams with electron energies representative of focused ion beam systems (e.g., with $eU \leq 30$ keV) described in reference to FIGs. 8-13C.

In the present disclosure, various properties of the charged particle beam can be described with reference to rays characterizing the charged particle beam. In particular, the systems described herein can be described as operating in a regime in which the constituent particles of the charged particle beam travel along substantially straight paths unless such paths are blocked, bent, and/or deflected by other components of the systems. Accordingly, many principles of ray optics can be applied to such charged particle beams.

A spatial extent of the charged particle beam can be characterized with reference to any suitable coordinate system. In the present disclosure, a position of a portion (e.g., a portion of a ray) of the charged particle beam can be described with reference to an x component as measured along an x-axis, a y component as measured along a y-axis, and a z component as measured along a z-axis. In the present disclosure, the z-axis generally corresponds to an optical axis along which the charged particle beam travels, which in some cases can be a curved axis. The x-axis and the y-axis can extend along any suitable directions such that the x-axis, the y-axis, and the z-axis are mutually perpendicular to one another.

*Multipoles*

As used herein, the term "multipole element" can refer to any suitable component with a plurality of poles, or electrodes, to which respective voltages can be applied to generate a multipole field. For example, a multipole element with four poles can be configured to generate at least a quadrupole field. Similarly, a multipole element with six poles can be configured to generate at least a hexapole field. In the present disclosure, a multipole element may be named and/or described with reference to the multiplicity of a multipole field that the multipole element is configured to produce (e.g., as a primary or sole multipole field generated by the multipole element). For example, a "quadrupole-generating element" can have four or more poles to generate at least a quadrupole field, and/or can have one or more poles that are shaped to produce at least a quadrupole field. Similarly, a "hexapole-generating element" can have six or more poles to generate at least a hexapole field, and/or can have one or more poles that are shaped to produce at least a hexapole field.

In some examples, a multipole element additionally or alternatively can be configured to generate any of a variety of multipole fields (and/or superpositions thereof). For example, in some examples, a hexapole-generating element with six poles can be configured to generate dipole fields, quadrupole fields, and/or hexapole fields. Unless otherwise stated, references herein to multipole fields (e.g., dipole fields, quadrupole fields, hexapole fields, octupole fields, etc.) generally refer to electrostatic multipole fields.

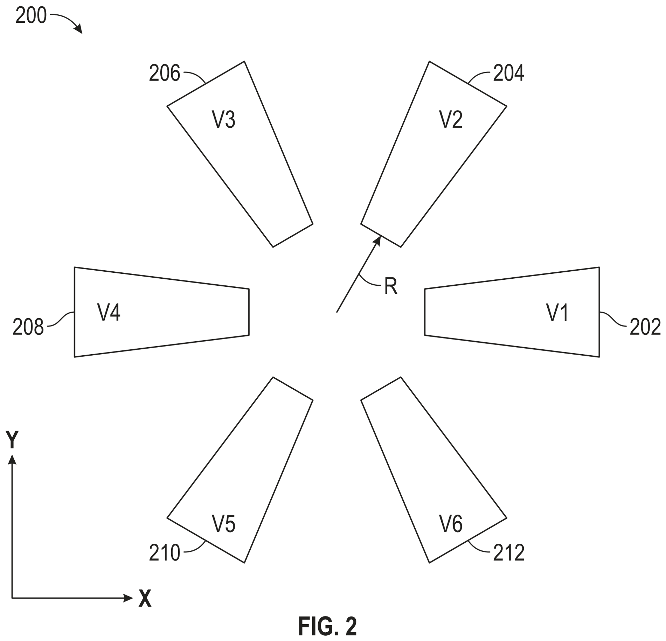

As an example, FIG. 2 illustrates an example of an electrostatic hexapole-generating element 200 that includes six electrodes 202, 204, 206, 208, 210, and 212 to which respective voltages $V_1, V_2, ... , V_6$ can be applied. With one such hexapole-generating element, one can generate dipole and quadrupole electrostatic fields of any orientation in the xy-plane and/or a hexapole field of fixed orientation.

We consider Cc-correcting devices in which the curved deflector optical axis lies in one plane, and we define the y-axis to be perpendicular to that plane. If we exclude the small multipole fields that are needed to correct for the effect of mechanical errors (i.e., ignoring parasitic aberrations), then all electrostatic multipole potentials are symmetric in y; that is, $\phi(x, y, z) = \phi(x, -y, z)$, in which case the hexapole potential is given by $\phi_3(x, y, z) = a_3(z)(x^3 - 3xy^2)$ + fringe field terms.

FIG. 2 illustrates an example in which the electrostatic field generated by the hexapole-generating element 200 is tunable via selection of the voltages applied to each electrode. In particular, a hexapole field is generated if $V_1 = V_3 = V_5 = V$ and $V_2 = V_4 = V_6 = -V$. Alternatively, a dipole field $E_x$ is generated if $V_1 = V$, $V_2 = V/2$, $V_3 = -V/2$, $V_4 = -V$, $V_5 = -V/2$, and $V_6 = V/2$ and a dipole field $E_y$ is generated if $V_1 = 0$, $V_2 = V$, $V_3 = V$, $V_4 = 0$, $V_5 = -V$, and $V_6 = -V$. Similarly, any linear combination of dipole, quadrupole, and/or hexapole fields can be generated. In other examples, and as discussed in more detail below, the shapes of the electrodes of a multipole element can generate a multipole field of fixed orientation corresponding to such shapes.

An electrostatic multipole potential of multiplicity m that satisfies the symmetry condition $\phi_m(x, y, z) = \phi_m(x, -y, z)$ is given by

$$\phi_m(x, y, z) = a_m(z)\text{Re}[(x + iy)^m] = a_m(z)r^m \cos(m\varphi) \qquad (1)$$

excluding fringe field terms, and with $x = r\cos(\theta)$ and $y = r\sin(\theta)$. The multiplicity m takes the value m = 1 for dipole fields, m = 2 for quadrupole fields, etc. Without the symmetry condition, equation (1) extends to

$$\phi_m(x, y, z) = a_m(z)\text{Re}[(x + iy)m] + b_m(z)\text{Im}[(x + iy)^m]$$

$$= a_m(z)r^m \cos(m\varphi) + b_m(z)r^m \sin(m\varphi). \qquad (2)$$

*First Order Rays*

First order rays of the charged particle beam, also known as Gaussian rays, can be characterized by five ray parameters. One such parameter is the relative energy spread $\kappa = \Delta U/U$. The remaining four parameters typically represent orthogonal components of the position and angle of the ray in a given plane, such as the specimen plane $z = z_S$ in which the sample is positioned. In particular, these parameters can be represented as the $x$ and $y$ components of the ray in the sample plane, represented as $x_S$ and $y_S$, respectively, as well as the angles of the $x$ and $y$ components of the ray in the sample plane, represented as $x'_s = \alpha$ and $y'_s = \beta$, respectively. Ignoring the off-axial fundamental ray components that are less relevant to a probe-forming system, the first order rays thus can be represented as

$$x(z) = \alpha \cdot x_a(z) + \kappa \cdot x_\kappa(z) \qquad (3)$$

and

$$y(z) = \beta \cdot y_a(z), \qquad (4)$$

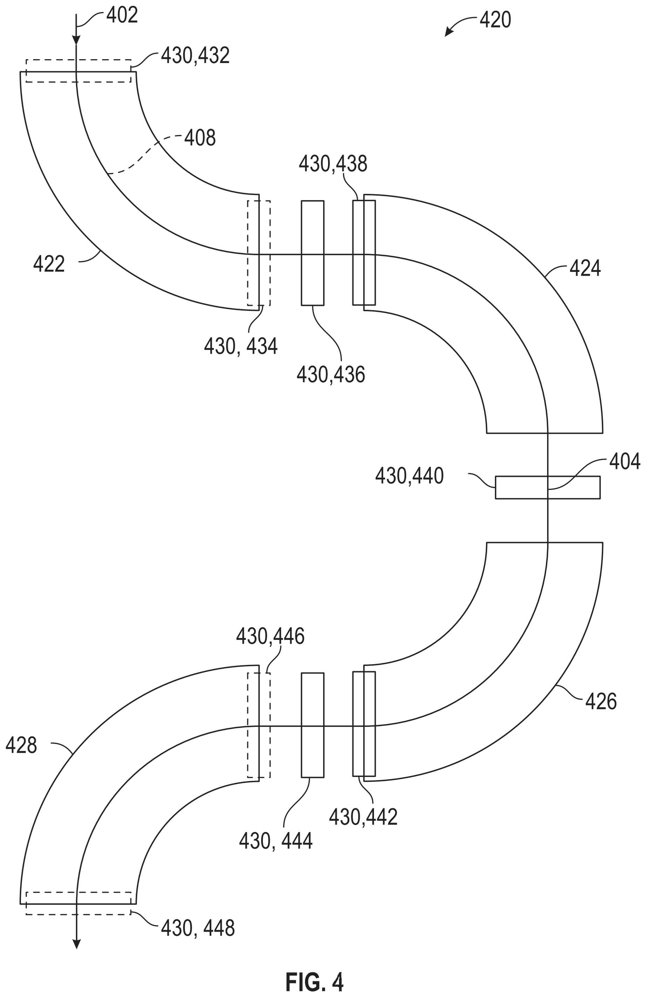

where $x_a(z)$ and $y_a(z)$ represent axial rays and $x_\kappa(z)$ represents a dispersion ray. Examples of such rays are illustrated in FIG. 4, discussed below.

*Axial Geometric Aberrations*

Geometric axial aberrations of the charged particle beam in the specimen plan can be defined via a phase function $S(\alpha, \beta)$, in which $\alpha = x' = dx/dz$ and $\beta = y' = dy/dz$. This function features as $\exp(i2\pi\lambda^{-1}S(\alpha, \beta))$ in wave-optical expressions, in which $\lambda$ is the charged particle wavelength. Excluding parasitic aberrations, $S(\alpha, \beta)$ contains only even powers of $\beta$, due to the symmetry of the electrostatic potential, and is then given by

$$S(\alpha, \beta) = \frac{1}{2}C_1(\alpha^2 + \beta^2) + \frac{1}{2}A_{1r}(\alpha^2 - \beta^2) +$$

$$B_{2r}\alpha(\alpha^2 + \beta^2) + \frac{1}{3}A_{2r}(\alpha^3 - 3\alpha\beta^2) +$$

$$\frac{1}{4}C_3(\alpha^2 + \beta^2) + S_{3r}(\alpha^2 - \beta^2)(\alpha^2 + \beta^2) + \frac{1}{4}A_{3r}(\alpha^4 - 6\alpha^2\beta^2 + \beta^4) +$$

$$\frac{1}{6}C_5(\alpha^2 + \beta^2)^3 + \cdots \qquad (5)$$

If parasitic aberrations are included, then an extension of equation (5) is needed, in which all aberration coefficients except $C_1$, $C_3 = C_S$, and $C_5$ are complex. For example, the terms for coma $B_{2r}$ and three-fold astigmatism $A_{2r}$ then extend to

$$\mathrm{Re}(B_2\omega^2\overline{\omega}) + \frac{1}{3}\mathrm{Re}(A_2\overline{\omega}^3), \qquad (6)$$

in which $B_2 = B_{2r} + iB_{2i}$, $A_2 = A_{2r} + iA_{2i}$, $\omega = \alpha + i\beta$, and $\overline{\omega} = \alpha - i\beta$. Third-order aberrations are spherical aberration $C_3$, star aberration $S_{3r}$ (which is two-fold), and four-fold astigmatism $A_{3r}$. Position aberrations in the specimen plane are given by $\delta x = \partial S/\partial\alpha$ and $\delta y = \partial S/\partial\beta$. The equivalent equation in complex notation is $\delta u = \delta x + i\delta y = 2\,\partial S(\omega, \overline{\omega})/\partial\overline{\omega}$. For example, second-order aberrations are given by

$$x = (3B_{2r} + A_{2r})\alpha^2 + (B_{2r} - A_{2r})\beta^2 \equiv \langle x|\alpha^2\rangle\alpha^2 + \langle x|\beta^2\rangle\beta^2, \qquad (7)$$

$$y = 2(B_{2r} - A_{2r})\alpha\beta \equiv \langle y|\alpha\beta\rangle\alpha\beta. \tag{8}$$

In these equations, the $\langle.|..\rangle$ notation is used to represent aberration coefficients that do not have well established symbols. For example, in an expression of the form $\delta x = c_1\alpha^2 + c_2\beta^2$, the coefficients can be denoted as $c_1 = \langle x|\alpha^2\rangle$ and $c_2 = \langle x|\beta^2\rangle$.

*Off-Axial Geometric Aberrations*

While geometric axial aberrations are particularly relevant to a probe-forming charged particle beam, off-axial aberrations also are relevant. For example, off-axial aberrations can determine a sensitivity of components of the charged particle microscope to drift of the incoming charged particle beam. Additionally, for sufficiently small off-axial aberrations, alternating current (AC) scanning advantageously can be done partly upstream of the aberration correction system.

All geometric aberrations can be conveniently described by an image-side perturbation eikonal function $S(\alpha, \beta, x_S, y_S)$, in which the additional ray parameters $x_S$ and $y_S$ are defined in the specimen plane $z = z_S$. The function $S(\alpha, \beta, 0, 0)$ is equal to the phase function $S(\alpha, \beta)$ presented in equation (5). The relations

$$\delta x = \partial S/\partial\alpha \text{ and } \delta y = \partial S/\partial\beta \tag{9}$$

remain valid; additionally, angle aberrations are given by

$$\delta x' = -\partial S/\partial x_S \text{ and } \delta y' = -\partial S/\partial y_S. \tag{10}$$

For correctors according to the present disclosure, second-order aberrations are most relevant. Ignoring parasitic aberrations, the corresponding image-side eikonal is given by

$$S_2(\alpha, \beta, x_S, y_S) = B_{2r}\alpha(\alpha^2 + \beta^2) + \frac{1}{3}A_{2r}(\alpha^3 - 3\alpha\beta^2) +$$

$$\frac{1}{2}\langle x|\alpha x_S\rangle\alpha^2 x_S + \frac{1}{2}\langle y|\beta x_S\rangle\beta^2 x_S + \langle x|\beta y_S\rangle\alpha\beta y_S, \tag{11}$$

which features five independent coefficients. The three off-axial aberration coefficients $\langle.|..\rangle$ yield

$$\delta x = \langle x|\alpha x_S\rangle\alpha x_S + \langle x|\beta y_S\rangle\beta y_S \tag{12}$$

and

$$\delta y = \langle y|\beta x_S\rangle\beta x_S + \langle x|\beta y_S\rangle\alpha y_S. \tag{13}$$

Unless all three off-axial coefficients are zero, beam drift above the corrector (resulting in nonzero $x_S$ and/or $y_S$) thus will induce defocus and/or astigmatism, i.e., the aberrations that are first-order in $\alpha$ and $\beta$. As a result of equation (10), the three off-axial aberration coefficients are determined via the angle aberrations of the axial beam:

$$\delta x' = -\frac{1}{2}\langle x|\alpha x_S\rangle\alpha^2 - \frac{1}{2}\langle y|\beta x_S\rangle\beta^2 \text{ and } \delta y' = -\langle x|\beta y_S\rangle\alpha\beta. \tag{14}$$

Hence, $\langle x'|\alpha^2\rangle = -\frac{1}{2}\langle x|\alpha x_S\rangle$, $\langle x'|\beta^2\rangle = -\frac{1}{2}\langle y|\beta x_S\rangle$, and $\langle y'|\alpha\beta\rangle = -\langle x|\beta y_S\rangle$.

Third order off-axial aberrations also can be relevant; the corresponding terms in the perturbation eikonal function are then proportional to $\alpha^3 x_S$, $\alpha\beta^2 x_S$, $\alpha^2\beta y_S$, and $\beta^3 y_S$, for inherent aberrations only. Also in this case, angle aberrations of the axial beam provide these off-axial aberrations. Mirror symmetry in the $xz$-plane corresponds to the constraint that the terms ... $\beta^n y_S^m$ only appear if $n + m$ is an even number.

*Chromatic Aberrations*

The axial chromatic aberration of round lenses is characterized by the coefficient $C_c$, with corresponding aberrations

$$\delta x = -C_c \alpha \frac{\Delta U}{U} = -C_c \alpha \kappa \text{ and } \delta y = -C_c \beta \kappa, \tag{15}$$

in which $eU$ equals the electron energy. For correctors according to the present disclosure, this is generalized to

$$\delta x = -C_{cx} \alpha \kappa \text{ and } \delta y = -C_{cy} \beta \kappa. \tag{16}$$

Alternatively, in examples in which $C_{cx} \neq C_{cy}$, one can use the chromatic aberration coefficient $C_c = (C_{cx} + C_{cy})/2$ and the chromatic astigmatism coefficient $A_{1\kappa,r} = )C_{cx} - C_{cy})/2 = \text{Re}(A_{1\kappa})$, so in general $\delta u = \delta x + i\delta y = -C_c \omega \kappa + A_{1\kappa} \bar{\omega} \kappa$, in which $\omega = \alpha + i\beta$.

Correctors according to the present disclosure can be designed such that the charged particle beam exiting the corrector is completely free of dispersion. Stated differently, the dispersion ray can coincide with the optical axis below the corrector such that the first-degree aberrations $\langle x|\kappa \rangle$ and $\langle x'|\kappa \rangle$ are zero here, and in particular at the sample.

In the present disclosure, aberrations may be characterized by an order and/or a degree. In particular, as used herein, the term "order" corresponds to the geometric part of the aberration, while the term "degree" refers to the power of $\kappa$ in an aberration. As an example, the chromatic aberration coefficient $C_c$ represents an aberration of order 1 and degree 1. As another example, the spherical aberration coefficient $C_3$ represents an aberration of order 3 and degree 0. Additionally, as used herein, the term "rank" represents the sum of the order and the degree of an aberration.

*Second Rank Aberrations*

For a perfect device, all relevant second rank aberrations can be derived from the image-side perturbation eikonal

$$S_2(\alpha, \beta, \kappa) = B_{2r}\alpha(\alpha^2 + \beta^2) + \frac{1}{3}A_{2r}(\alpha^3 - 3\alpha\beta^2) + \frac{1}{2}C_{cx}\alpha^2\kappa + \frac{1}{2}C_{cy}\beta^2\kappa + \langle x|\kappa^2 \rangle \alpha\kappa^2 +$$

$$\frac{1}{2}\langle x|\alpha x_S \rangle \alpha^2 x_S + \frac{1}{2}\langle y|\beta x_S \rangle \beta^2 x_S + \langle x|\beta y_S \rangle \alpha\beta y_S, \tag{17}$$

in which the first line contains the axial aberration coefficients, and in which the second line contains the (only geometric) off-axial aberration coefficients. The ray angles $\alpha = x'(z_S)$ and $\beta = y'(z_S)$ represent ray angles in the specimen plane $z = z_S$, while $x_S$ and $y_S$ are position coordinates in the specimen plane, $\kappa = \Delta U/U$ represents the relative energy deviation, and position aberrations in the specimen plane are given by $\delta x = \partial S/\partial \alpha$ and $\delta y = \partial S/\partial \beta$.

Second rank parasitic aberrations can be represented as

$$S_{2,\text{par.}}(\alpha, \beta, \kappa) = -B_{2i}\beta(\alpha^2 + \beta^2) + \frac{1}{3}A_{2i}(3\alpha^2\beta - \beta^3) + A_{1i,\kappa}\alpha\beta\kappa +$$

$$\frac{1}{2}\langle x|\alpha y_S \rangle \alpha^2 y_S + \frac{1}{2}\langle y|\beta y_S \rangle \beta^2 y_S + \langle x|\beta x_S \rangle \alpha\beta x_S. \tag{18}$$

The latter three off-axial aberrations generally are negligible and need not be considered in the design of the corrector.

*First Rank Aberrations*

Aside from parasitic defocus and astigmatism $C_1$ and $A_1$, which can be trivially nullified, the first-degree parasitic dispersion is important:

$$S_{1,\text{par.}} = \langle x|\kappa\rangle\alpha\kappa + \langle y|\kappa\rangle\beta\kappa \qquad (19)$$

$$\delta x = \langle x|\kappa\rangle\kappa \qquad (20)$$

$$\delta y = \langle y|\kappa\rangle\kappa \qquad (21)$$

*Hexapole Fields for Second Rank Aberrations*

In an ideal device, hexapole fields can affect the axial second rank aberrations $A_{2r}$, $B_{2r}$, $C_{cx}$, $C_{cy}$, and $\langle x|\kappa^2\rangle$. If desired, additional hexapole fields can be applied to reduce or nullify one or more of the off-axial aberration coefficients $\langle x|\alpha y_S\rangle$, $\langle x|\beta y_S\rangle$, and $\langle x|\beta x_S\rangle$, in order to make the corrector insensitive to drift of the charged particle beam above the corrector.

For an actual device subject to parasitic aberrations, additional hexapole fields may be needed to nullify $A_{2i}$ and $B_{2i}$, preferably in regions in which $x_\kappa = 0$. Additional hexapole fields also may be needed to nullify the chromatic astigmatism component $A_{1\kappa,i}$. The corresponding hexapole potentials then are of the form

$$\phi_3(x, y, z) = \widetilde{a_3}(z)(y^3 - 3x^2 y) + \text{fringe field terms}. \qquad (22)$$

*Aberrations induced by thin multipoles*

For a multipole element of relatively short length $L$ positioned at $z = z_M$, the hexapole potential of the multipole element in the sharp cutoff of fringe fields (SCOFF) approximation is given by

$$\phi_3 = a_3(x^3 - 3xy^2) \qquad (23)$$

for $z_M - L/2 < z < z_M + L/2$, and $\phi_3 = 0$ outside this region. In other words, $a_3(z)$ is a "rectangular" or "top-hat" function. Electrode voltages lie approximately within the range $\pm a_3 R^3$, where R is the inner radius of the multipole element. The electric field is given by $E_x = -\partial\phi_3/\partial x$ and $E_y = -\partial\phi_3/\partial y$. To good approximation, the hexapole field induces small deflection angles

$$\theta_x = \frac{3L}{2U}a_3(x^2 - y^2) \text{ and}$$

$$\theta_y = -\frac{3L}{U}a_3 xy, \qquad (24)$$

and the resulting second rank aberrations in the specimen plane $z = z_S$ are then given by

$$\delta x = -\theta_x \cdot x_a(z_M) = -\frac{3L}{2U}a_3(x^2 - y^2) \cdot x_a(z_M) \text{ and}$$

$$\delta y = \frac{3L}{U}a_3\, x\, y\, \cdot y_a(z_M), \qquad (25)$$

in which the lateral electron position $(x, y)$ is given by

$$x(z) = \alpha \cdot x_a(z_M) + \kappa \cdot x_\kappa(z_M) \text{ and}$$

$$y(z) = \beta \cdot y_a(z_M). \qquad (26)$$

As an example, for a hexapole field at $z = z_M$ at which there is no dispersion (i.e., $x_\kappa(z_M) = 0$) and at which the axial beam is round (i.e., $x_a(z_M) = y_a(z_M) \equiv x_a$), then equations ( 25) and ( 26) yield

$$\delta x = -\frac{3L}{2U} a_3 x_a^3 \cdot (\alpha^2 - \beta^2) \text{ and } \delta y = \frac{3L}{2U} a_3 x_a^3 \cdot 2\alpha\beta, \tag{27}$$

such that the real part of the coefficient for three-fold astigmatism $A_{2r}$ in the specimen plane is given by

$$A_{2r} = -\frac{3La_3}{2U} x_a^3. \tag{28}$$

Generalizing to a case in which $x_a(z_M) \neq y_a(z_M)$ and in which $x_\kappa(z_M) = 0$, the results for astigmatism $A_{2r}$ and coma $B_{2r}$ are

$$A_{2r} = -\frac{3La_3}{8U} x_a(x_a^2 + 3y_a^2) \text{ and } B_{2r} = \frac{3La_3}{8U} x_a(y_a^2 - x_a^2). \tag{29}$$

Generally, for nonzero dispersion in the thin multipole element (i.e., $x_\kappa \neq 0$), the axial second rank aberrations induced by a hexapole field are $A_{2r}$, $B_{2r}$, $C_{cx}$, $C_{cy}$, and second degree dispersion $\langle x|\kappa^2 \rangle$.

*Chromatic Aberration Correction in the yz-plane*

In many examples, the fundamental ray $x_a(z_{mid}) = 0$ in the corrector mid-plane $z = z_{mid}$, and $y_a(z_{mid})$ and $x_\kappa(z_{mid})$ are large there. In such examples, $C_c$-correction in the yz-plane preferably is performed with a tunable hexapole-generating element in the corrector mid-plane. Assuming equal radius $R_{prism}$ for all electrostatic prisms, $x_\kappa(z_{mid}) = g_1 R_{prism}$, in which $|g_1| \sim 2$ for the alpha-type correctors discussed below and $|g_1| \sim 3$ for the omega-type correctors discussed below. Combining equations (22) and (23) yields

$$\delta y = \frac{3La_3}{U} x_\kappa y_a^2 \cdot \kappa\beta \tag{30}$$

in the specimen plane, with $y_a = y_a(z_{mid})$ and $x_\kappa = x_\kappa(z_{mid})$. With reference to equation (16), it can be seen that

$$C_{cy} = -\frac{3La_3}{U} x_\kappa y_a^2, \tag{31}$$

where the sign is determined by the hexapole polarity (i.e., the sign of $a_3$). As a result, the mid-plane hexapole field can nullify $C_{cy}$ of the full optical column.

In the xz-plane, the mid-plane hexapole field induces an angle

$$\theta_x = \frac{3La_3}{2U} (x_\kappa^2 \kappa^2 - y_a^2 \beta^2). \tag{32}$$

This does not lead to a position aberration $\delta x$, because the mid-plane is imaged onto the specimen plane in the xz-plane, but the second term ($\propto \beta^2$) does result in an angle aberration of the axial beam, which translates into an off-axial aberration as outlined above. The corresponding aberration coefficient is $\langle y|\beta x_s \rangle$; the eikonal term $\frac{1}{2}\langle y|\beta x_s \rangle \beta^2 x_s$ leads to

$\delta x' = -\frac{1}{2}\langle y|\beta x_s \rangle \beta^2$ and $\delta y = \langle y|\beta x_s \rangle \beta x_s$ in the specimen plane. Accordingly, if the charged particle source drifts in (for example) the x-direction, this leads to defocus in the yz-plane. In some examples, this off-axial aberration can be nullified, such as by applying a hexapole field in a similar line focus (i.e., where $x_a = 0$) in a position at which there is little or no dispersion (i.e., where $x_\kappa$ is small).

*Chromatic Aberration Correction in the xz-plane*

In some examples, chromatic aberration correction in the xz-plane is performed with two hexapole fields, positioned at two line foci at $z = z_A$ and $z = z_C$, where $y_a(z_A) = y_a(z_C) = 0$. Additionally, in such examples, $x_\kappa(z_A) = x_\kappa(z_C) \equiv x_\kappa$

and $x_a(z_A) \cdot\cdot x_a(z_C) \equiv x_a$. Pure correction of $C_{cx}$ requires a symmetric excitation of both hexapole fields, but it is useful to treat the general case in which the hexapole excitations are $a_3 + \varepsilon$ at $z = z_A$ and $a_3 - \varepsilon$ at $z = z_C$. These hexapole fields only cause a deflection at $\theta_x$:

$$\theta_x(z_A) = \frac{3L}{2U}(a_3 + \epsilon)(\alpha x_a + \kappa x_\kappa)^2 \text{ and } \theta_x(z_C) = \frac{3L}{2U}(a_3 - \epsilon)(-\alpha x_a + \kappa x_\kappa)^2. \qquad (33)$$

Accordingly, the total position aberration in the specimen plane is given by

$$\delta x = -\frac{3L}{2U}\left(-x_a \cdot (a_3 + \epsilon)(\alpha x_a + \kappa x_\kappa)^2 + x_a \cdot (a_3 - \epsilon)(-\alpha x_a + \kappa x_\kappa)^2\right)$$

$$= -\frac{3L}{U}\left(2x_\kappa x_a^2 a_3 \cdot \kappa\alpha + \epsilon(x_a^2 \cdot \alpha^2 + x_\kappa^2 \cdot \kappa^2)\right). \qquad (34)$$

For symmetric excitation (i.e., $\varepsilon = 0$), there is only one aberration:

$$C_{cx} = \frac{6La_3}{U}x_\kappa x_a^2. \qquad (35)$$

Equation (34) shows that an asymmetric excitation can be used to tune second-degree dispersion $\langle x|\kappa^2 \rangle$, but that such an excitation also generates the second-order aberration $\langle x|\alpha^2 \rangle$, which must be compensated elsewhere. Such compensation can be performed in another location of line focus of the charged particle beam, where also $y_a = 0$ and where there is little to no dispersion, i.e., where $x_\kappa \approx 0$. In such an example, a hexapole field in this line focus can primarily or exclusively generate a counterbalancing aberration coefficient $\langle x|\alpha^2 \rangle$.

Such hexapole fields also can cause an off-axial aberration with corresponding aberration coefficient $\langle x|\alpha x_S \rangle$. The eikonal term $\frac{1}{2}\langle x|\alpha x_S \rangle \alpha^2 x_S$ results in both $\delta x' = -\frac{1}{2}\langle x|\alpha x_S \rangle \alpha^2$ and $\delta x = \langle x|\alpha x_S \rangle \alpha x_S$ in the specimen plane. This off-axial aberration does not occur in the omega-type examples discussed below, because the two hexapole fields that correct for $C_{cx}$ are imaged onto each other not only in the yz-plane but also in the xz-plane, such that the second-order geometric aberrations cancel each other completely.

*Chromatic Aberration Corrector Examples*

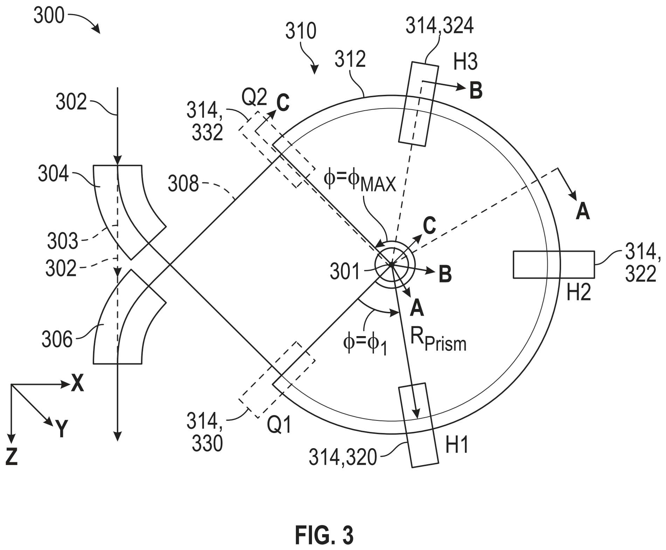

FIG. 3 illustrates an aberration correction system 300 for at least partially correcting an axial chromatic aberration of a charged particle beam 302. The aberration correction system 300 may be described as representing an example of the aberration correction system 120 of FIG. 1. Similarly, the charged particle beam 302 can include and/or be the charged particle beam 104 of FIG. 1.

As shown in FIG. 3, the aberration correction system 300 includes a deflector assembly 310 that includes a corrector electrostatic prism 312 and a plurality of electrostatic multipole elements 314. As shown in FIG. 3, the deflector assembly 310 can define a deflector optical axis 308 such that the charged particle beam 302 travels along the deflector optical axis 308 as the charged particle beam 302 traverses the aberration correction system 300. The deflector assembly 310 thus may be configured to at least partially correct an axial chromatic aberration in the charged particle beam 302 as the charged particle beam 302 travels along the deflector optical axis 308. In the example of FIG. 3, the deflector optical axis 308 is a curved axis that is circular within the corrector electrostatic prism 312. Within the corrector electrostatic prism 312, the circular path of the deflector optical axis 308 can be characterized by a prism radius $R_{prism}$, as measured between a central axis 301 of the corrector electrostatic prism 312 and the deflector optical axis 308.

The corrector electrostatic prism 312 can be configured to generate at least a portion of an electrostatic deflection field associated within the corrector electrostatic prism 312 that directs the charged particle beam 302 along the curved deflector optical axis 308. The electrostatic deflection field can include a prism hexapole field, such as may be generated by at least a subset of the plurality of electrostatic multipole elements 314.

As shown in FIG. 3, the aberration correction system 300 additionally includes an entry electrostatic prism 304 configured to direct (e.g., deflect) the charged particle beam 302 toward and/or to the deflector optical axis 308, such as from an optical column axis 303, and an exit electrostatic prism 306 configured to direct (e.g., deflect) the charged particle beam 302 from the deflector optical axis 308, such as toward and/or to the optical column axis 303. The optical column axis 303 may represent at least a portion of the optical column axis 112 of FIG. 1. In this manner, the optical column axis 303 may be described as excluding the deflector optical axis 308 such that the deflector optical axis 308 represents and/or includes a path of a portion of the charged particle beam 302 that is deflected away from the optical column axis 303.

The entry electrostatic prism 304 and the exit electrostatic prism 306 each may have any of a variety of structures and/or configurations for directing the charged particle beam 302 as described. In some examples, each of the entry electrostatic prism 304 and the exit electrostatic prism 306 is configured to deflect the charged particle beam 302 through an angle that is equal, or approximately equal, to 45 degrees. This is not required, however, and it additionally is within the scope of the present disclosure that the entry electrostatic prism 304 and the exit electrostatic prism 306 each can deflect the charged particle beam 302 through an angle that is greater than or less than 45 degrees. Additionally or alternatively, in some examples, the entry electrostatic prism 304 and the exit electrostatic prism 306 can be configured to deflect the charged particle beam 302 by different amounts (e.g., through respective angles that are different from one another).

In some examples, one or both of the entry electrostatic prism 304 and the exit electrostatic prism 306 is a double-focusing prism. Additionally or alternatively, in some examples, one or both of the entry electrostatic prism 304 and the exit electrostatic prism 306 can be characterized by focusing action that is different in different planes (e.g., in the xz-plane and in the yz-plane as shown in FIG. 3).

In some examples, the entry electrostatic prism 304 and the exit electrostatic prism 306 can be configured to selectively direct the charged particle beam 302 to travel along the deflector optical axis 308 or alternatively to bypass the corrector electrostatic prism 312 (e.g., to continue traveling along the optical column axis 303). For example, the aberration correction system 300 can be configured to be selectively operated in each of a correction mode, in which the entry electrostatic prism 304 directs the charged particle beam 302 toward the deflector optical axis 308, and a straight-axis mode, in which the charged particle beam bypasses the deflector assembly 310. In some such examples, and as shown in dashed lines in FIG. 3, the aberration correction system 300 can be configured such that, when the aberration correction system 300 is in the straight-axis mode, the charged particle beam 302 travels through each of the entry electrostatic prism 304 and the exit electrostatic prism 306 without deflection. This can be accomplished, for example, by configuring each of the entry electrostatic prism 304 and the exit electrostatic prism 306 to include apertures and/or passages through which the charged particle beam 302 can pass without deflection when no deflecting voltage is applied to each prism.

In the present disclosure, a particle beam (e.g., the charged particle beam 104 and/or the charged particle beam 302) may be described as traveling "along" a direction and/or axis (e.g., the emission axis 106, the optical column axis 112, the optical column axis 303, and/or the deflector optical axis 308) even when and/or where at least a portion of the particle beam spatially departs from the direction and/or axis. For example, and as discussed herein, a particle beam may be characterized by a nonzero spatial extent in a direction perpendicular to its direction of travel in at least a portion of a beam path of the particle beam. Accordingly, in the present disclosure, an axis along which a particle beam travels can refer to a path encompassed and/or surrounded by the particle beam and/or a path that characterizes an average motion of the particles of the particle beam. Additionally or alternatively, a curved axis along which a particle beam travels can be defined to coincide with the central axial ray of the particle beam; that is, a ray of the charged particle beam that travels exactly along a straight optical axis upstream of the curved optical axis prior to being deflected onto the curved optical axis. Stated differently, this central axial ray may be described as representing the ray at the center of the axial beam cone.

Additionally, in the present disclosure, an axis (e.g., the emission axis 106, the optical column axis 112, the optical column axis 303, and/or the deflector optical axis 308) characterizing a beam path of a particle beam (e.g., the charged particle beam 104 and/or the charged particle beam 302) can follow a curved trajectory. In particular, in the example of FIG. 3, the deflector optical axis 308 traversing the deflector assembly 310 may be described as being $\alpha$-shaped (that is, shaped in a similar manner to the Greek letter alpha). Additionally, in the example of FIG. 3, a portion of the deflector optical axis 308 extending within the corrector electrostatic prism 312 follows a circular path. In the present disclosure, any example of an aberration correction system and/or of a deflector assembly thereof that is characterized by a deflector optical axis that is generally $\alpha$-shaped can be referred to as an "alpha-type" system or assembly.

In the example of FIG. 3, the plurality of electrostatic multipole elements 314 includes a first hexapole-generating element 320, a second hexapole-generating element 322, a third hexapole-generating element 324, a first quadrupole-generating element 330, and a second quadrupole-generating element 332.

As shown in FIG. 3, at least a subset of the plurality of electrostatic multipole elements 314 (e.g., at least the first hexapole-generating element 320, the second hexapole-generating element 322, and the third hexapole-generating element 324) can be at least partially positioned and/or incorporated within the corrector electrostatic prism 312. In particular, while FIG. 3 shows each electrostatic multipole element 314 as partially overlapping the corrector electrostatic prism 312 for clarity, it is to be understood that each electrostatic also can be at least substantially and/or fully contained within the corrector electrostatic prism 312.

In some examples, each of the first hexapole-generating element 320, the second hexapole-generating element 322, and the third hexapole-generating element 324 includes six poles for generating a respective hexapole field (e.g., as a primary or sole multipole field). In other examples, one or more of the first hexapole-generating element 320, the second hexapole-generating element 322, and/or the third hexapole-generating element 324 can include more than six poles (e.g., eight poles) in order to generate small additional multipole fields (e.g., a rotated hexapole field) to nullify parasitic aberrations caused by mechanical errors. Additionally or alternatively, one or more of the electrostatic multipole elements 314 can be configured to generate small dipole fields and/or small quadrupole fields. Such dipole fields can operate to align the central ray of the charged particle beam 302. Such quadrupole fields can operate to align the first order rays of the charged particle beam 302.

In some examples, a quadrupole-generating element of an aberration correction system according to the present disclosure (e.g., the first quadrupole-generating element 330 and/or the second quadrupole-generating element 332) can include four poles for generating a respective quadrupole field (e.g., as a primary or sole multipole field). In other examples, a quadrupole-generating element can include more or fewer than four poles.

In some examples, a multipole element of an aberration correction system according to the present disclosure can be configured to generate a corresponding multipole field as a result of a geometry of the multipole element and/or of a corresponding structure. For example, a portion of an electrostatic prism (e.g., the corrector electrostatic prism 312, the entry electrostatic prism 304, and/or the exit electrostatic prism 306) can be shaped such that application of deflecting voltages to the electrostatic prism yields a multipole field component in addition to the deflection electrostatic field.

As another example, a multipole element that is configured primarily to produce a first type of multipole field (e.g., a quadrupole field) may include poles that are shaped to additionally produce additional types of multipole fields (e.g., octupole fields, 12-pole fields, etc.). That is, while it often is desirable to configure a multipole element to produce a corresponding multipole field that is as "pure" as possible (e.g., to produce a hexapole field with minimal quadrupole, octupole, etc. field components), it also can be desirable in other instances to configure a single multipole element to produce a superposition of multiple multipole fields. In some examples, this can simplify the design of a system by enabling the use of fewer optical elements and/or applied voltages to produce the desired fields.

In the present disclosure, such geometry-related multipole fields may be described as being "fixed" and/or "static," in the sense that such fields are of a type and/or orientation that are fixed by the geometry of the corresponding structure. Such fields additionally or alternatively may be referred to herein as "auxiliary fields." Such auxiliary fields may be variable in magnitude by varying the voltages that are applied to the structures that produce such auxiliary fields; however, since such voltages typically are applied to achieve a different primary effect (e.g., deflection of a charged particle beam along a well-defined direction and/or production of a different primary multipole field), the magnitude of the auxiliary field generally is not independently variable. Accordingly, the desired configuration of an auxiliary field generally must be achieved through careful shaping of the corresponding structures rather than through control of applied voltages.

In some examples, and as shown in FIG. 3, each of the first quadrupole-generating element 330 and the second quadrupole-generating element 332 can be configured to produce a corresponding auxiliary quadrupole field (e.g., as a primary or sole multipole field). In particular, each of the first quadrupole-generating element 330 and the second quadrupole-generating element 332 can be at least partially defined by the corrector electrostatic prism 312, such as via suitable shaping of the corrector electrostatic prism 312 where the deflector optical axis 308 enters and exits the corrector electrostatic prism 312.

Each of the first hexapole-generating element 320, the second hexapole-generating element 322, and the third hexapole-generating element 324 primarily is configured to generate a respective hexapole field, but also can generate small, fine-tuning dipole and/or quadrupole fields. Specifically, the first hexapole-generating element 320 is configured to generate a first hexapole field, the second hexapole-generating element 322 is configured to generate a second hexapole field, and the third hexapole-generating element 324 is configured to generate a third hexapole field.

Similarly, each of the first quadrupole-generating element 330 and the second quadrupole-generating element 332 primarily is configured to generate a respective quadrupole field. Specifically, the first quadrupole-generating element 330 is configured to generate a first quadrupole field and the second quadrupole-generating element 332 is configured to generate a second quadrupole field.

In the Figures of the present disclosure, an electrostatic multipole element illustrated and/or represented in solid lines, such as the first hexapole-generating element 320, the second hexapole-generating element 322, or and the third hexapole-generating element 324 of FIG. 3, represents an electrostatic multipole element that is configured to generate corresponding multipole fields that are tunable (e.g., in orientation and/or magnitude). In such examples, the illustrated solid lines additionally or alternatively may be understood as representing the corresponding tunable multipole field. In such examples, and as described herein, such tunable multipole fields can be generated and/or configured in any of a variety of manners, such as by applying independently controllable voltages to respective poles of the multipole elements in order to generate a desired multipole field with one or more degrees of freedom.

Alternatively, in the Figures of the present disclosure, an electrostatic multipole element illustrated and/or represented in dashed lines, such as the first quadrupole-generating element 330 or the second quadrupole-generating element 332 of FIG. 3, represents an electrostatic multipole element that is configured to generate a corresponding auxiliary multipole field. In such examples, the illustrated dashed lines additionally or alternatively may be understood as representing the corresponding auxiliary multipole field. In such examples, and as described herein, such auxiliary multipole fields can be generated and/or configured in any of a variety of manners, such as via appropriate shaping of the electrodes of the associated multipole elements.

As shown in FIG. 3, the charged particle beam 302, the optical column axis 303, and/or the deflector optical axis 308 also may be characterized with reference to an x-axis, a *y*-axis, and a z-axis. In particular, the z-axis can be defined as a direction along which the deflector optical axis 308 is oriented at a given location along the deflector optical axis 308. The x-axis can be defined as a direction that is perpendicular to the z-axis at the given location along the deflector optical axis 308 and that extends within a plane within which the deflector optical axis 308 extends within the deflector assembly 310, while the *y*-axis can be defined as the direction mutually perpendicular to each of the x-axis and the z-axis.

As shown in FIG. 3, a location and/or position along a portion of the deflector optical axis 308 extending within the corrector electrostatic prism 312 can be characterized by a prism angle $\phi$ that can assume any value between zero and a maximum prism angle $\phi_{max}$. In particular, a prism angle of $\phi = 0$ can correspond to a location at which the charged particle beam 302 enters the corrector electrostatic prism 312 along the deflector optical axis 308, while a prism angle of $\phi = \phi_{max}$ can correspond to a location at which the charged particle beam 302 exits the corrector electrostatic prism 312 along the deflector optical axis 308. In this manner, the angle $\phi_{max}$ may be described as representing the full angular extent of the corrector electrostatic prism 312 and/or the total angle through which the charged particle beam 302 is deflected as the charged particle beam 302 traverses the corrector electrostatic prism 312.

The angle $\phi_{max}$ can assume any of a variety of values. In particular, in the example of FIG. 3, the angle $\phi_{max}$ is equal, or approximately equal, to 270 degrees. This is not required of all examples, however, and it additionally is within the scope of the present disclosure that the angle $\phi_{max}$ can be less than or greater than 270 degrees.

In various examples, and as shown in FIG. 3, the sum of the angle $\phi_{max}$ and the respective angles through which the entry electrostatic prism 304 and the exit electrostatic prism 306 deflect the charged particle beam 302 is equal, or approximately equal, to 360 degrees such that the charged particle beam 302 travels along substantially the same direction upstream and downstream of the deflector assembly 310. Thus, in some examples, the corrector electrostatic prism 312 can be characterized by a maximum prism angle $\phi_{max} = 250$ degrees, and each of the entry electrostatic prism 304 and the exit electrostatic prism 306 can be configured to deflect the charged particle beam 302 through a 55-degree angle. Alternatively, in some other examples, the corrector electrostatic prism 312 can be characterized by a maximum prism angle $\phi_{max} = 280$ degrees, and each of the entry electrostatic prism 304 and the exit electrostatic prism 306 can be configured to deflect the charged particle beam 302 through a 40-degree angle.

The electrostatic multipole elements 314 of the deflector assembly 310 can have any of a variety of configurations relative to one another and/or relative to the corrector electrostatic prism 312. For example, and shown in FIG. 3, the first quadrupole-generating element 330 can be positioned along the deflector optical axis 308 between the entry electrostatic prism 304 and the first hexapole-generating element 320, while the second quadrupole-generating element 332 can be positioned along the deflector optical axis 308 between the third hexapole-generating element 324 and the exit electrostatic prism 306.

In the example of FIG. 3, the second hexapole-generating element 322 is positioned proximate to a midpoint of the deflector optical axis 308 within the corrector electrostatic prism 312. In particular, in the example of FIG. 3, the corrector electrostatic prism 312 is characterized by a maximum prism angle of $\phi_{max} = 270$ degrees, such that the second hexapole-generating element 322 is positioned and/or centered at a prism angle of $\phi = 135$ degrees.

Additionally, in the example of FIG. 3, each of the first hexapole-generating element 320 and the third hexapole-generating element 324 are angularly equidistant from the second hexapole-generating element 322 such that the deflector assembly 310 is mirror-symmetric in the mid-plane (i.e., about the center of the second hexapole-generating element 322). In particular, in the example of FIG. 3, the first hexapole-generating element 320 is positioned and/or centered at a prism angle of approximately $\phi = 58$ degrees, while the third hexapole-generating element 324 is positioned and/or centered at a prism angle of approximately $\phi = 212$ degrees. Such an arrangement is not required, however, and it additionally is within the scope of the present disclosure that the first hexapole-generating element 320 and the third hexapole-generating element 324 may be positioned at any suitable respective prism angles, such as at prism angles that correspond to locations at or near line foci of the charged particle beam 302 within the corrector electrostatic prism 312.

FIG. 4 illustrates aspects of another example of an aberration correction system 400 that includes four 90-degree electrostatic prisms 422, 424, 426, and 428 configured to direct a charged particle beam 402 along a deflector optical axis 408 that follows a generally Q-shaped path. The aberration correction system 400 may be described as representing an example of the aberration correction system 120 of FIG. 1. Similarly, the charged particle beam 402 can include and/or be the charged particle beam 104 of FIG. 1.

As shown in FIG. 4, the aberration correction system 400 includes a deflector assembly 420 with a first electrostatic prism 422, a second electrostatic prism 424, a third electrostatic prism 426, and a fourth electrostatic prism 428.

The first electrostatic prism 422, the second electrostatic prism 424, the third electrostatic prism 426, and the fourth electrostatic prism 428 can be arranged and/or coupled to one another in any suitable configuration. For example, at least the second electrostatic prism 424 and the third electrostatic prism 426 can be fixedly coupled to one another, and/or can represent respective components and/or portions of a single monolithic device. Additionally or alternatively, at least the first electrostatic prism 422 and the fourth electrostatic prism 428 can be fixedly coupled to one another, and/or can represent respective components and/or portions of a single monolithic device.

In the example of FIG. 4, each of the first electrostatic prism 422, the second electrostatic prism 424, the third electrostatic prism 426, and the fourth electrostatic prism 428 is configured to deflect the charged particle beam 410 through an angle that is equal, or approximately equal, to 90 degrees. This is not required, however, and it additionally is within the scope of the present disclosure that each electrostatic prism of the deflector assembly 420 can deflect the charged particle beam 410 through any suitable angle. In some examples, one or more of the first electrostatic prism 422, the second electrostatic prism 424, the third electrostatic prism 426, and/or the fourth electrostatic prism 428 is a double-focusing prism.

Each electrostatic prism of the deflector assembly 420 also can be characterized by a corresponding multipole strength and/or quadrupole parameter. In particular, with reference to Equation (37), each of the first electrostatic prism 422 and the fourth electrostatic prism 428 can be characterized by a quadrupole strength $a_2 = K^2 U$, and each of the second electrostatic prism 424 and the third electrostatic prism 426 can be characterized by a quadrupole strength $a_2 = \frac{3}{2} K^2 U$. In this manner, each of the second electrostatic prism 424 and the third electrostatic prism 426 can have a quadrupole strength of the same form as in a spherical deflector (but with a different hexapole strength $a_3$ than that of the spherical deflector).

As shown in FIG. 4, the deflector assembly 420 additionally includes a plurality of electrostatic multipole elements 430. Specifically, in the example of FIG. 4, the plurality of electrostatic multipole elements 430 includes a first multipole element 438 configured to generate a first hexapole field, a second multipole element 440 configured to generate a second hexapole field, and a third multipole element 442 configured to generate a third hexapole field.

In some examples, the deflector assembly 420 also can include one or more multipole elements configured to generate quadrupole fields. For example, and as shown in FIG. 4, the plurality of electrostatic multipole elements further can include a fourth multipole element 436 configured to generate a fourth element quadrupole field, a fifth multipole element 444 configured to generate a fifth element quadrupole field, a sixth multipole element 432 configured to generate a sixth element quadrupole field, a seventh multipole element 434 configured to generate a seventh element quadrupole field, an eighth multipole element 446 configured to generate an eighth element quadrupole field, and a ninth multipole element 448 configured to generate a ninth element quadrupole field.

Additionally, in this example, the first multipole element 438 also can be configured to generate a first element quadrupole field, and the third multipole element 442 also can be configured to generate a third element quadrupole field. In this manner, each of the first multipole element 438 and the third multipole element 442 may be described as representing each of a hexapole-generating element and a quadrupole-generating element.

The first element hexapole field and the first element quadrupole field generated by the first multipole element 438 can be at least partially overlapping (e.g., in space and/or along the deflector optical axis 408. For example, the first hexapole field and the first element quadrupole field may correspond to and/or be respective components of an electrostatic multipole field generated by the first multipole element 438.

The first multipole element 438 can have any suitable structure for generating the first hexapole field and the first element quadruple field. For example, the first multipole element 438 can include and/or be a hexapole-generating element that is configured to generate each of the first hexapole field and the first element quadrupole field when suitable voltages are applied to the six electrodes of the hexapole-generating element. Additionally or alternatively, the first multipole element 438 can include each of a quadrupole-generating element with four electrodes and a distinct hexapole-generating element with six electrodes respectively configured to generate the first hexapole field and the first element quadrupole field.

Similarly, the third hexapole field and the third element quadrupole field generated by the third multipole element 442 can be at least partially overlapping (e.g., in space and/or along the deflector optical axis 408. For example, the third hexapole field and the third element quadrupole field may correspond to and/or be respective components of an electrostatic multipole field generated by the third multipole element 442.

The third multipole element 442 can have any suitable structure for generating the third hexapole field and the third element quadrupole field. For example, the third multipole element 442 can include and/or be a hexapole-generating element that is configured to generate each of the third hexapole field and the third element quadrupole field when suitable voltages are applied to the six electrodes of the hexapole-generating element. Additionally or alternatively, the third multipole element 442 can include each of a quadrupole-generating element with four electrodes and a distinct hexapole-generating element with six electrodes respectively configured to generate the third hexapole field and the third element quadrupole field.

Similar to the examples discussed above, each electrostatic multipole element 430 illustrated in dashed lines in FIG. 4 represents an electrostatic multipole element that is configured to generate a corresponding auxiliary multipole field with one or more properties that are fixed by the multipole geometry, while each electrostatic multipole element illustrated in solid lines in FIG. 4 represents an electrostatic multipole element that is configured to generate a corresponding multipole field that is independently tunable (e.g., in orientation and/or magnitude). Thus, in the example of FIG. 4, each of the sixth multipole element 432, the seventh multipole element 434, the eighth multipole element 446, and the ninth multipole element 448 is configured to generate an auxiliary multipole field, while all other electrostatic multipole elements 430 are configured to generate a tunable multipole field.

In some examples, the first electrostatic prism 422 can include and/or define at least a portion of each of the sixth multipole element 432 and the seventh multipole element 434. For example, the entry and/or exit of the first electrostatic prism 422 can be shaped and/or otherwise configured to produce the sixth element quadrupole field and/or the seventh element quadrupole field, respectively, upon application of a deflecting voltage to the first electrostatic prism 422. In other examples, the sixth multipole element 432 and/or the seventh multipole element 434 can be fixedly coupled to the first electrostatic prism 422.

Similarly, in some examples, the fourth electrostatic prism 428 can include and/or define at least a portion of each of the eighth multipole element 446 and the ninth multipole element 448. For example, the entry and/or exit of the fourth electrostatic prism 428 can be shaped and/or otherwise configured to produce the eighth element quadrupole field and/or the ninth element quadrupole field, respectively, upon application of a deflecting voltage to the fourth electrostatic prism 428. In other examples, the eighth multipole element 446 and/or the ninth multipole element 448 can be fixedly coupled to the fourth electrostatic prism 428.

In the example of FIG. 4, the plurality of electrostatic multipole elements 430 are arranged in a mirror symmetric configuration about a midplane location 404 of the deflector optical axis 408 within the deflector assembly 420. For example, and as shown in FIG. 4, the second multipole element 440 can be positioned proximate to the midplane location 404, and the fourth multipole element 436, the first multipole element 438, the third multipole element 442, and the fifth multipole element 444 can be arranged in a mirror symmetric configuration about the second multipole element 440.

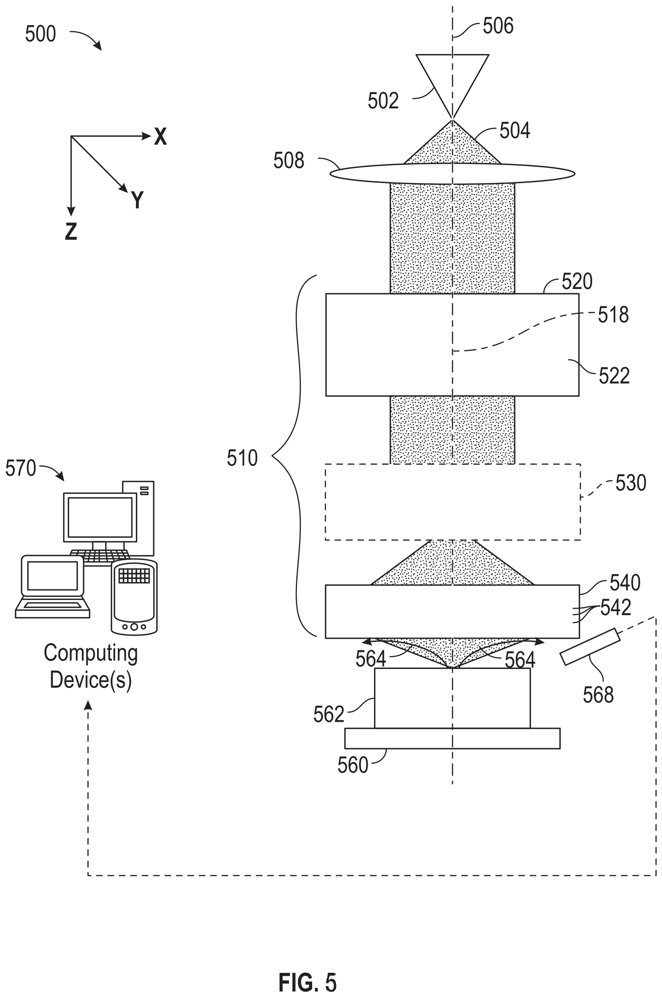

FIG. 5 illustrates another example of a charged particle microscope system 500 that can include and/or utilize aberration correction systems as disclosed herein. In particular, and as described in more detail below, the charged particle microscope system 500 can include a plurality of quadrupole and octupole electrostatic elements that collectively operate to strongly reduce or nullify the spherical aberration $C_S$ of a charged particle beam. Such a configuration can produce a large source demagnification in a relatively short optical column, which may be particularly beneficial for chromatic and/or spherical aberration corrected FIB systems and/or for plasma-FIB systems, because the focused probe is less blurred by Coulomb interactions in a shorter column.

The charged particle microscope system 500 of FIG. 5 is similar to the charged particle microscope system 100 of FIG. 1. For example, the charged particle microscope system 500 includes a charged particle source 502 that emits a charged particle beam 504 along an emission axis 506 and toward a focusing column 510 (which also may be referred to herein as an optical column 510). The charged particle beam 504 travels along an optical axis 518 through the focusing column 510. The optical axis 518 can include and/or be a curved optical axis, such as any of the deflector optical axes disclosed herein. As shown in FIG. 5, the charged particle microscope system 500 can include condenser optics 508 that accelerate/decelerate, focus, and/or direct the charged particle beam 504 toward the focusing column 510.

Downstream of the focusing column 510, the charged particle microscope system 500 includes a sample holder 560 that holds a sample 562 and a detector 568 that is configured to detect charged particles 564 that are discharged from the sample 562 as a result of the charged particle beam 504 being incident upon the sample 562. The charged particle microscope system 500 further can include one or more computing devices 570 programmed and/or configured to control operation of one or more aspects of the charged particle microscope system 500.

Except as discussed below, all illustrated components of the charged particle microscope system 500, labeled or unlabeled, can share any suitable features, characteristics, attributes, etc. with the corresponding components of the charged particle microscope system 100 of FIG. 1. Additionally, the charged particle microscope system 500 can include any suitable components and/or exhibit any suitable functionality disclosed herein with reference to the charged particle microscope system 100 of FIG. 1.

In the example of FIG. 5, the optical column 510 can be configured to at least partially correct an axial spherical aberration and/or an axial chromatic aberration of the charged particle beam 504. As shown in FIG. 5, the optical column 510 includes a multipole condenser 520 and a multipole objective 540 downstream of the multipole condenser 520. The multipole condenser 520 includes one or more condenser quadrupole-generating elements 522, while the multipole objective 540 includes a plurality of objective multipole elements 542. In some examples, one or more beam limiting apertures can be positioned upstream of the multipole condenser 520.

The plurality of objective multipole elements 542 can have any of a variety of configurations, examples of which are discussed in more detail below. In general, the plurality of objective multipole elements 542 includes at least three quadrupole-generating elements as well as at least three octupole-generating elements that are configured to at least partially correct a spherical aberration of the charged particle beam 504. In some examples, and as described in more detail below, one or more of the objective multipole elements 542 can operate to generate a quadrupole field as well as an octupole field, and thus may be described as representing both a quadrupole-generating element and an octupole-generating element.

In some examples, and as shown in FIG. 5, the optical column additionally includes a chromatic aberration corrector 530 positioned between the multipole condenser 520 and the multipole objective 540. In such examples, the chromatic aberration corrector 530 can include and/or be any suitable apparatus for at least partially correcting an axial chromatic aberration of the charged particle beam 504. In other examples, chromatic aberration in the charged particle beam 504 can be at least partially corrected by an emitter corrector.

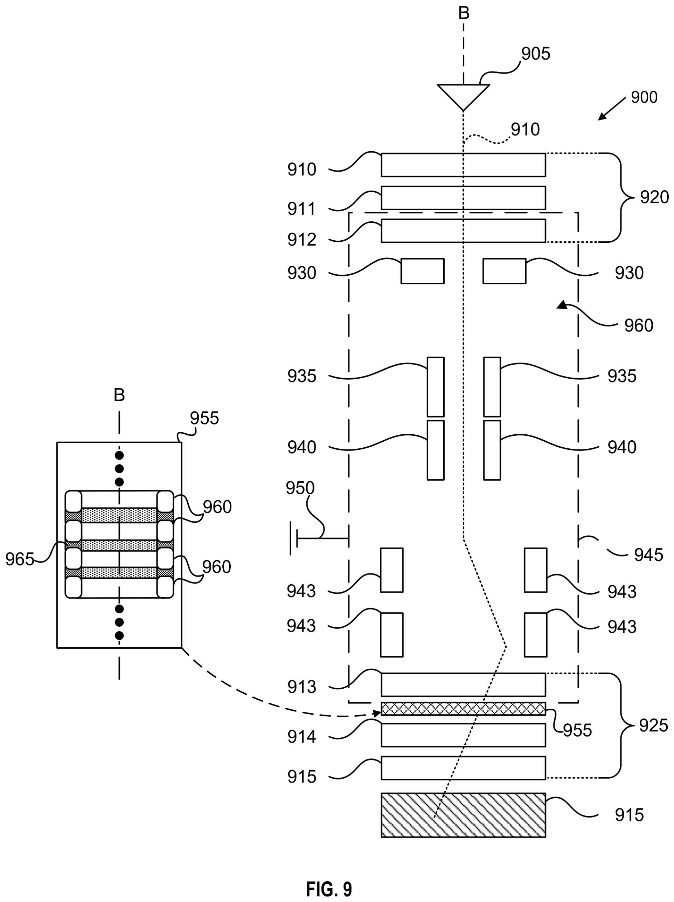

Similar to the charged particle microscope system 100 of FIG. 1, the charged particle microscope system 500 can include and/or be one or more different types of ion beam systems and/or charged particle microscopes, examples of which include a focused ion beam (FIB) system, dual beam (FIB-SEM) system, etc. Accordingly, the charged particle source 502 can be configured to emit the charged particle beam 504 with any suitable accelerating voltage, such as an accelerating voltage that corresponds to the type of ion beam processing being performed. As examples, the charged particle source 502 can be configured to emit the charged particle beam 504 with an accelerating voltage that is at least 200 volts (V), at least 1,000 V, at least 5,000 V, at least 10,000 V, at least 20,000 V, at least 30,000 V, at most 60,000 V, at most 30,000 V, at most 15,000 V, at most 7,000 V, at most 2,000 V, and/or at most 500 V. As described in more detail in reference to FIGs. 9-13C, the energy of the beam 504 can be modified using one or more charged particle optical elements of the optical column 510, such as the acceleration systems 905, 1005, 1105, 1205, etc. of FIGs. 9-12.

The charged particle source 502 can emit the charged particle beam 504 toward the optical column 510 that directs the charged particle beam 504 toward a sample position 560. The charged particle beam 504 travels along an optical axis 506 through the optical column 510.

The chromatic aberration corrector 530 can include one or more prisms (e.g., an entry electrostatic prism, a corrector electrostatic prism, and an exit electrostatic prism), a plurality of electrostatic quadrupole-generating elements, and a plurality of electrostatic hexapole-generating elements. The chromatic aberration corrector 530 can be similar to the aberration correction system 300 of FIG. 3.

The multipole condenser 520 can include a quadrupole doublet. The quadrupole doublet can include a first condenser quadrupole-generating element and a second condenser quadrupole-generating element positioned downstream of the first condenser quadrupole-generating element. The first condenser quadrupole-generating element can be configured to generate a first condenser quadrupole field, while the second condenser quadrupole-generating element can be configured to generate a second condenser quadrupole field. In other examples, the multipole condenser 520 can include a single quadrupole-generating element.

The multipole objective 540 can include a plurality of objective multipole elements, examples of which are described in reference to FIG. 2 and FIGs 6-7. The plurality of objective multipole elements can include a first objective multipole element, a second objective multipole element positioned downstream of the first objective multipole element, and a third objective multipole element positioned downstream of the second objective multipole element. The first objective multipole element, the second objective multipole element, and the third objective multipole element can be configured to generate a first objective multipole field, a second objective multipole field, and a third objective multipole field, respectively.

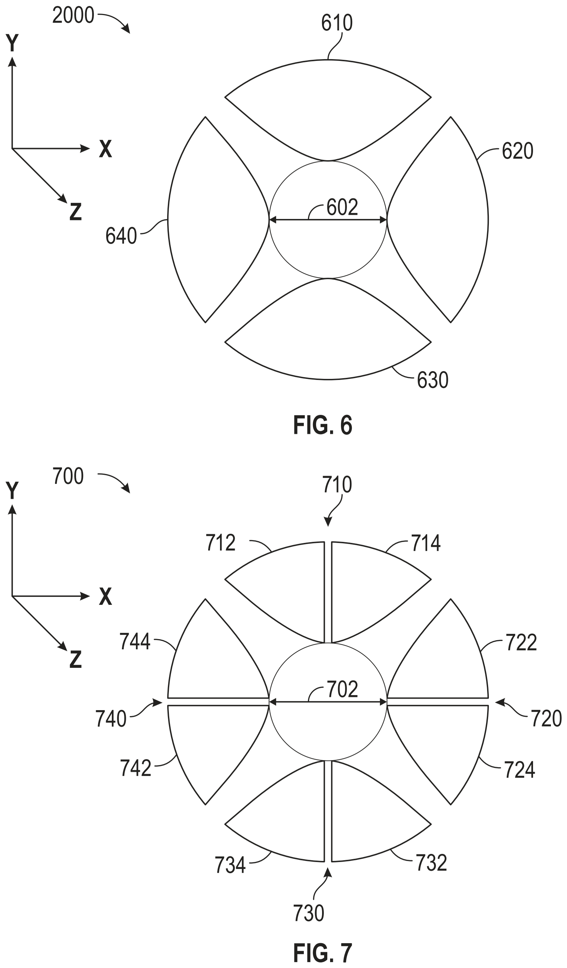

Each electrostatic multipole element of the charged particle microscope system 500 and/or of the charged particle microscope system 500 can have any suitable configuration for generating the corresponding multipole fields. As an example, FIG. 6 illustrates an example of a multipole element 600 that includes a first electrode 610, a second electrode 620, a third electrode 630, and a fourth electrode 640, each configured to receive a corresponding voltage to generate a respective component of the corresponding multipole field. Accordingly, the multipole element 600 may be referred to as a quadrupole-generating element 600 and/or may be configured to generate a quadrupole field. Stated differently, the multipole element 600 can be configured such that the multipole field generated by the multipole element 600 includes a quadrupole field as a primary constituent multipole field.

In some examples, however, the multipole element 600 also can be configured such that the multipole field generated by the multipole element 600 further includes additional multipole field components, such as an octupole field component. In particular, each of the first electrode 610, the second electrode 620, the third electrode 630, and the fourth electrode 640 can be configured (e.g., shaped) such that the total multipole field generated by the multipole element 600 includes a quadrupole field component and an octupole field component. In some examples, the relative magnitudes and/or respective configurations of the quadrupole and octupole fields generated by the multipole element 600 can be controlled via application of appropriate respective voltages to the electrodes of the multipole element 600 and/or via suitable shaping of the electrodes of the multipole element 600.

As shown in FIG. 6, the multipole element 600 can be characterized by a multipole element inner diameter 602 that represents a minimum separation distance between opposed electrodes, as measured along a direction perpendicular to the z-axis in FIG. 6. The multipole element inner diameter 602 additionally or alternatively may be described as representing a maximum diameter of a charged particle beam that passes through the multipole element 600. The multipole element inner diameter 602 can assume any of a variety of values, such as a value in the range of about 1-5 millimeters (mm).

FIG. 7 illustrates another example of a multipole element 700 that can represent any suitable multipole element of the charged particle microscope system 500. In the example of FIG. 7, the multipole element 700 includes a first electrode pair 710, a second electrode pair 720, a third electrode pair 730, and a fourth electrode pair 740. The first electrode pair 710 includes a first electrode 712 and a second electrode 714; the second electrode pair 720 includes a third electrode 722 and a fourth electrode 724; the third electrode pair 730 includes a fifth electrode 732 and a sixth electrode 734; and the fourth electrode pair 740 includes a seventh electrode 742 and an eighth electrode 744.

In some examples, the multipole element 700 of FIG. 7 may be configured to generate a quadrupole field as a primary multipole field. For example, the multipole element 700 can be configured such that each of the first electrode pair 710, the second electrode pair 720, the third electrode pair 730, and the fourth electrode pair 740 can receive a respective voltage for generating a corresponding quadrupole field. Accordingly, in such examples, the multipole element 700 may be described as representing a quadrupole-generating element.

Additionally or alternatively, the multipole element 700 can be configured such that each of the first electrode 712, the second electrode 714, the third electrode 722, the fourth electrode 724, the fifth electrode 732, the sixth electrode 734, the seventh electrode 742, and the eighth electrode 744 can receive a respective voltage for generating the corresponding multipole field. In such examples, the multipole element 700 may be configured to operate as a quadrupole-generating element for aberration correction as described herein, as well as to generate small deflection fields superimposed on the quadrupole field to scan a charged particle beam relative to a sample. In particular, configuring the multipole element 700 such that different deflection voltages may be applied to each electrode of each electrode pair an facilitate generating such deflection fields while minimizing the generation of undesirable multipole fields (e.g., hexapole fields) that can introduce additional aberrations.

In some examples, the multipole element 700 additionally or alternatively may be configured to generate an octupole field (e.g., as a primary or sole multipole field). In some examples, the relative magnitudes and/or respective configurations of the octupole and quadrupole fields generated by the multipole element 700 can be controlled via application of appropriate respective voltages to the electrodes of the multipole element 700 and/or via suitable shaping of the electrodes of the multipole element 700.

As shown in FIG. 7, a multipole element can be characterized by a multipole element inner diameter 702 that represents a minimum separation distance between opposed electrodes, as measured along a direction perpendicular to the z-axis in FIG. 7. The multipole element inner diameter 702 additionally or alternatively may be described as representing a maximum diameter of a charged particle beam that passes through the multipole element 700. The multipole element inner diameter 702 can assume any of a variety of values, such as a value in the range of about 1-5 mm.

The charged particle microscope system 800 of FIG. 8 includes a multipole objective 840 that includes four objective multipole elements. Specifically, in the example of FIG. 8, the multipole objective 840 includes a first objective multipole element 844, a second objective multipole element 846 positioned downstream of the first objective multipole element 844, a third objective multipole element 848 positioned downstream of the second objective multipole element 846, and a fourth objective multipole element 850 positioned downstream of the third objective multipole element 848.

The first objective multipole element 844, the second objective multipole element 846, the third objective multipole element 848, and the fourth objective multipole element 850 are configured to generate a first objective multipole field, a second objective multipole field, a third objective multipole field, and a fourth objective multipole field, respectively. In particular, in the example of FIG. 8, the first objective multipole field includes a first objective quadrupole field component and a first objective field octupole field component. The second objective multipole field includes a second objective octupole field component. The third objective multipole field includes a third objective quadrupole field component and a third objective octupole field component. The fourth objective multipole field includes a fourth objective quadrupole field component. In this manner, the plurality of objective multipole elements 23442 may be described as including exactly three quadrupole-generating elements. Stated differently, in this example, exactly three objective multipole elements 23442 are configured to generate quadrupole field components.

Each of the objective multipole elements 842 can have any suitable form and/or configuration for generating the corresponding objective multipole field. In some examples, each of the first objective multipole element 844 and the third objective multipole element 848 comprises four electrodes that are shaped to produce octupole fields in addition to quadrupole fields. As an example, one or both of the first objective multipole element 844 and the third objective multipole element 848 can be similar to, and/or can be, the multipole element 700 of FIG. 7. Additionally or alternatively, in some examples, the fourth objective multipole element 850 can include eight electrodes for producing both quadrupole and octupole fields. As an example, the fourth objective multipole element 850 can be similar to, and/or can be, the multipole element 700 of FIG. 7.

Such a configuration is not required of all examples, however. For example, it also is within the scope of the present disclosure that one or more of the first objective multipole element 844, the second objective multipole element 846, and/or the third objective multipole element 848 can have eight electrodes in the manner of the multipole element 700 of FIG. 7. Additionally or alternatively, the fourth objective multipole element 850 can have four electrodes that are shaped to produce octupole fields in the manner of the multipole element 700 of FIG. 7.

FIG. 9 is a schematic diagram of a charged particle optical system 900, in accordance with embodiments of the present disclosure. The system 900 forms part of an ion beam column (e.g., ion column 110 of FIG. 1) oriented relative to a source of ions 905 and configured to receive a beam 910 of ions oriented along an axis, B. The axis, B, is illustrated as substantially centered and linear along a length of the system 900, extending toward a sample position 915. The system 900 includes a first lens system 920, a second lens system 925, a beam defining aperture (BDA) 930, a steering assembly 935, a blanking assembly 940, a multipole assembly 943, a conducting element 945, bias circuitry 950, and a deceleration element 955.

The conducting element 945 can be disposed about the axis B and can terminate at a first end proximal to the deceleration element 955. The conducting element 945 can define an inner volume 960. In some embodiments, at least a portion of the aberration correction system is disposed in the inner volume 960. The conducting element 945 can be operably coupled with the bias circuitry 950. The bias circuitry 950 can be configured to apply a bias to the conducting element 945, such that optical components disposed at least partially within the inner volume 960 can be configured to operate relative to the bias applied.

The conducting element 945 can include metal, composite, and/or insulating materials. In an illustrative example, the conducting element 945 can include a titanium alloy. The inclusion of electrically conductive material surrounding the inner volume 960 permits those components of the ion optical column that are disposed in the inner volume to be electrically insulated from ground potential. The effects of electrically insulating optical elements permits the beam of ions 910 to maintain a relatively high average energy across the inner volume.

The conducting element 945 can be a non-physical, or "virtual" element. To that end, the conducting element can include a system of bias circuitry 950 electrically coupled with various components of the ion column. For example, the conducting element 945 can include bias circuitry 950 coupled with the lens 912, the beam defining aperture (BDA) 930, the steering assembly 935, the blanking assembly 940, the multipole assembly 943, and the lens 912. The components of the conducting element 945 can be configured to apply a bias voltage to components of the ion column, such that the ions of the beam of ions 910 are shielded from a ground potential with which some components of the system 900 are electrically coupled.

The deceleration element 955 can include one or more of electrodes 960, mutually isolated and disposed on the axis B. An electrode 960 of the deceleration element 955 can be annular, such as a solid cylinder, a perforated cylinder, a toroid, or the like. The deceleration element 955 can be substantially centered about the axis B. In some embodiments, the deceleration element 955 includes multiple electrodes 960, mechanically coupled via an insulating material 965. The electrode(s) 960 can be coupled with a voltage circuit that configure the deceleration element 955 to reduce the average energy of the beam of ions 910. In some embodiments, the deceleration element 955 is a charged particle optical element configured as a transfer lens, a condenser lens, or the like, and thereby configured to modify the average energy of the beam 910.

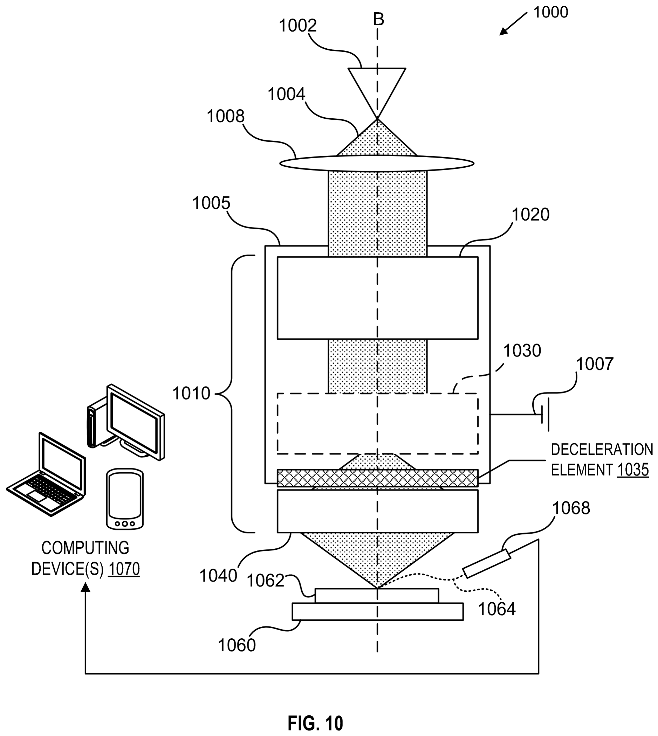

In some embodiments, the conducting element 945 generates a negative electric field in a vicinity of the ion beam 910. Advantageously, a size of a beam spot formed by focusing the ion beam 910 at the sample position (e.g., by the action of an objective lens assembly) can be reduced via the action of the conducting element 945. Without being bound to a particular physical explanation or mechanism of action, the conducting element 945 can attenuate spreading of the ion beam 910 that can be attributed at least in part to mutual repulsion among ions. As a further advantage, the conducting element 945 can improve the energy spread and spatial resolution of the ion beam 910. Embodiments of the present disclosure present further advantages, as described in more detail in reference to FIGs. 10-14.

Based at least in part on a reduction of energy spread in the beam 910, the action of the conducting element 945 can improve the performance of corrector optics of optical aberrations of the beam of ions 910, including those described in reference to FIGs. 1-8. The improvement to aberration correction can be attributed at least in part to the sensitivity of corrector optics to beam energy spread, where attenuation of optical aberrations diminishes relatively steeply with increasing deviation from the calibration energy, as described in reference to FIGs. 1-3.

To that end, embodiments of the present disclosure include charged optical assemblies including the conducting element 945, deceleration element 955, and one or more aberration correction optics, such as the multipole assemblies 943, configured such that the aberration correction optics are disposed on the beam axis B between the source 905 and the deceleration element 955, as described in reference to FIGs. 10-14. Advantageously, the configurations of charged particles optics described herein exhibit improved aberration correction at relatively high beam energy upstream of the deceleration element 955 and improved objective lens performance at relatively low energy, downstream of the deceleration element 955.

FIG. 10 is a schematic diagram of a charged particle beam system 1000 including a deceleration element 1035 as part of a physical acceleration system, in accordance with embodiments of the present disclosure. System 1000 is an example of the charged particle system 500 of FIG. 5 including a charged particle source 1002 configured to emit an ion beam 1004 along a beam axis B and toward a charged particle column 1010 (which also may be referred to herein as an optical column 1010). System 1000 further includes the deceleration element 1035 in which at least a portion of the components of the system 1000 are disposed. The ion beam 1004 can be directed along the axis B via the acceleration system 1005 and the optical column 1010. The axis B can include one or more linear and/or curved segments, such as any of the deflector optical axes disclosed herein. The system 1000 can include condenser optics 1008, configured to accelerate and/or decelerate the ions of the ion beam 1004, focus, and/or direct the ion beam 1004 toward the optical column 1010.

The optical column 1010 can include a multipole condenser 1020, one or more aberration correction optics, and a multipole objective 1040. Downstream of the focusing column 1010, the charged particle microscope system 1000 includes a sample holder 1060 that holds a sample 1062 and a detector 1068 that is configured to detect charged particles 1064 emanating from the sample 1062. The charged particle microscope system 1000 further can include one or more computing devices 1070 programmed and/or configured to control operation of one or more aspects of the charged particle microscope system 1000.

The optical column 1010 can include the chromatic aberration corrector 1030 positioned between the multipole condenser 1020 and the multipole objective 1040. The chromatic aberration corrector 1030 can include and/or be any suitable apparatus for at least partially correcting an axial chromatic aberration of the charged particle beam 1004. In some cases, chromatic aberration in the charged particle beam 1004 can be at least partially corrected by an emitter corrector. Examples of the aberration corrector 1030 include those described in reference to FIGs. 1-8.

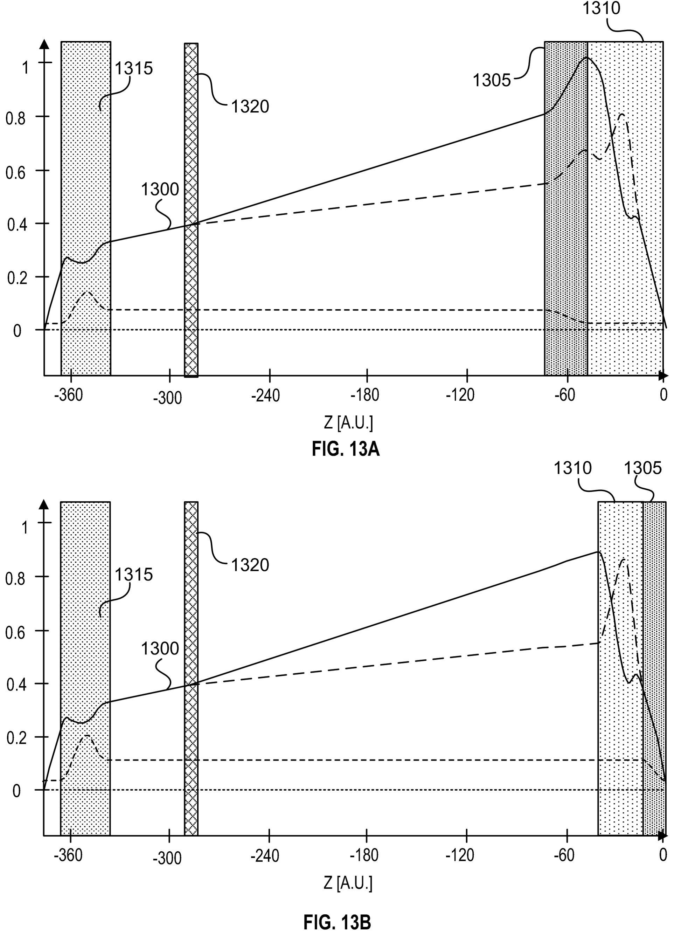

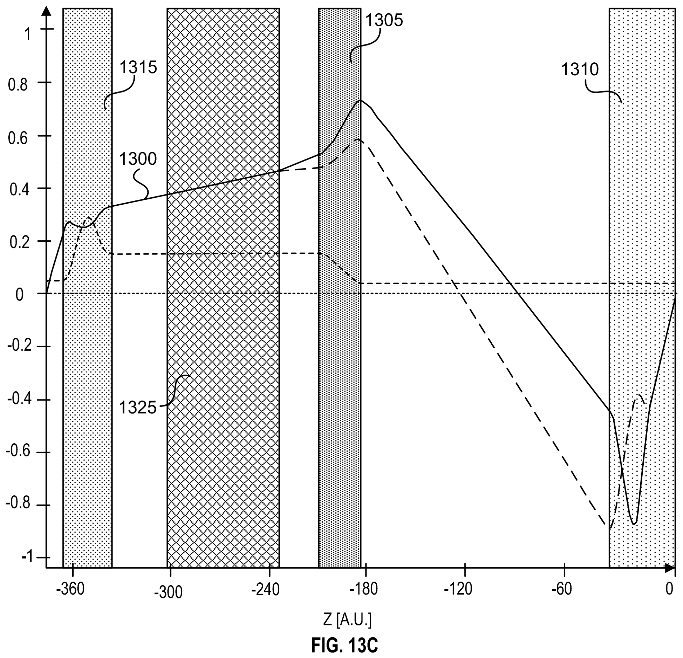

In the example embodiment shown in FIG. 10, at least portions of the multipole condenser 1020 and of the chromatic aberration corrector 1030 are disposed within a physical conducting element of the acceleration system 1005, electrically coupled with bias circuitry 1007 configured to apply a voltage to the physical conducting element. The physical conducting element can be structured as described in reference to FIG. 9. For example, the acceleration system 1005 can include a metal cylinder that can formed of a solid material, a perforated material, or the like. The operation of the ion beam system 1000 is demonstrated in the ray diagram of FIG. 13A, illustrating a deceleration element 1035 disposed upstream of the multipole objective 1040. An example embodiment in which the chromatic aberration corrector 1030 defines curved axis, as described in reference to FIG. 3, is demonstrated in the ray diagram of FIG. 13C.

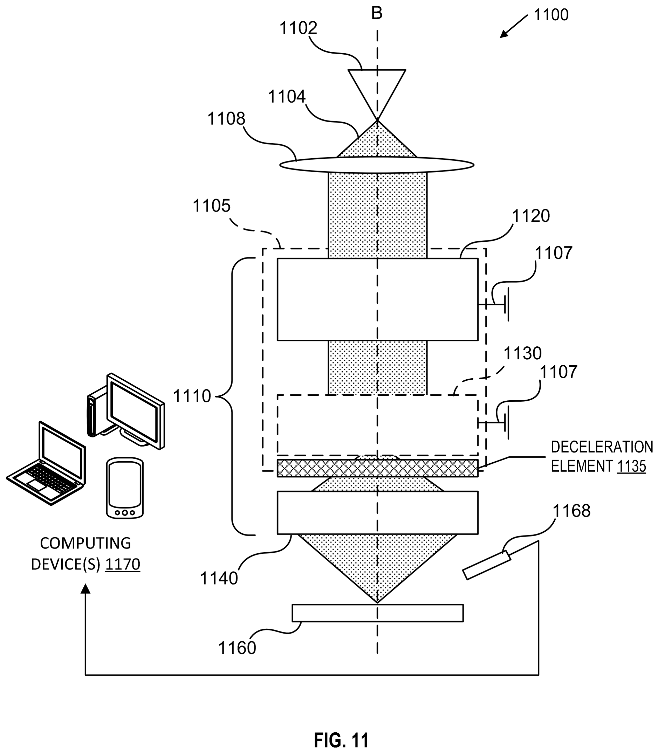

FIG. 11 is a schematic diagram of a charged particle beam system 1100 including a deceleration element 1135 as part of a virtual acceleration system, in accordance with embodiments of the present disclosure. The system 1100 is configured in a similar arrangement as that described in reference to system 1000 of FIG. 10., including a charged particle source 1102 configured to emit an ion beam 1104, one or more condenser optics 1008, a charged particle optical column 1110, a multipole condenser 1120, the deceleration element 1135, one or more aberration correction optics 1130, and a multipole objective 1140. Downstream of the optical column 1110, the charged particle microscope system 1100 includes a sample holder 1160 and a detector 1168. The system 1100 further can include one or more computing devices 1170 programmed and/or configured to control operation of one or more aspects of the system 1100.

Similar to the system 1000 of FIG. 10, the deceleration element 1135 is disposed along the axis B between the aberration correction optics 1130 and the multipole objective 1140. In contrast to FIG. 10, however, the system 1100 includes a virtual conducting element, as described in reference to FIG. 9. To that end, the acceleration system 1105, can include bias circuitry 1107 configured to apply a bias voltage to the components of the optical column 1110 that are to be shielded from the ground potential and thereby attenuate the broadening effect of the ground potential on the ion beam 1104, as described in more detail in reference to FIG. 9. The operation of the ion beam system 1000 is demonstrated in the ray diagram of FIG. 13A, illustrating a deceleration element 1035 disposed upstream of the multipole objective 1040.

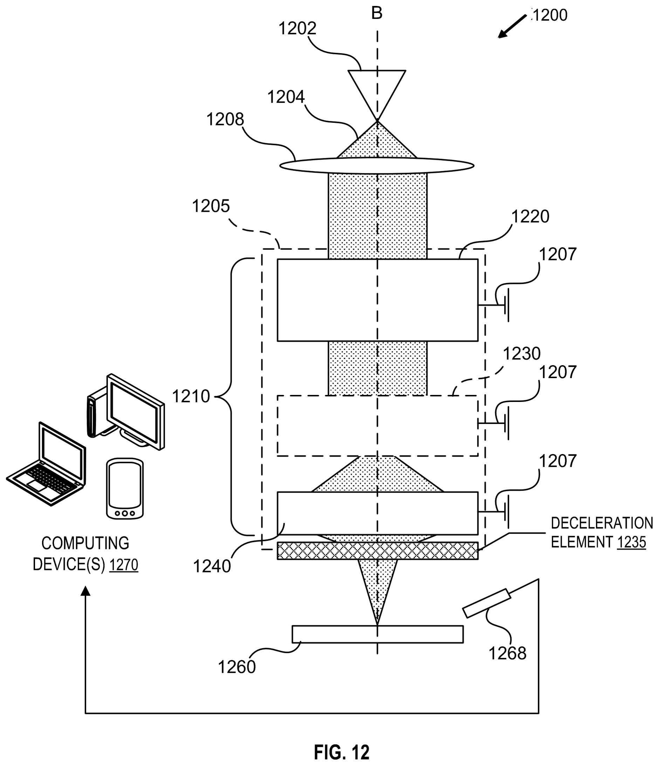

FIG. 12 is a schematic diagram of a charged particle beam system 1200 including a deceleration element 1235 disposed between a multipole objective 1240 and a sample stage 1260, in accordance with embodiments of the present disclosure. The system 1200 is configured in a similar arrangement as that described in reference to system 1100 of FIG. 11., including a charged particle source 1202 configured to emit an ion beam 1204, one or more condenser optics 1208, a charged particle optical column 1210, a multipole condenser 1220, the deceleration element 1235, one or more aberration correction optics 1230, and a multipole objective 1240. Downstream of the optical column 1210, the charged particle microscope system 1200 includes a sample holder 1260 and a detector 1268. The system 1200 further can include one or more computing devices 1270 programmed and/or configured to control operation of one or more aspects of the system 1200. As in system 1100 of FIG. 11, the acceleration system 1205 includes bias circuitry 1207, electrically coupled with one or more of the components of the optical column 1210, such that the acceleration system defines a virtual conducting element as described in more detail in reference to FIG. 9.

In contrast to the system 1100 of FIG. 11, the deceleration element 1235 of system 1200 is disposed between the multipole objective 1240 and the sample position 1260. A diagram illustrating the operation of the system 1200 is provided in FIG. 13B. Advantages of including the multipole objective among the elements operating as part of the acceleration system 1205 include improved energy resolution of the beam, from which an improvement to the performance of the multipole objective can be derived.

In FIGs. 13A-13C, data illustrating the performance of ion beam systems of the present disclosure are provided. The plots define a lateral 'x' axis in spatial units, denoting a relative position along a beam axis, with zero indicating the objective crossover (e.g., at the sample position). Each plot includes three rays, where the solid (-) and long-dashed (- -) lines describe the spatial spread of a beam of ions 1300 at various positions along the beam axis in orthogonal spatial directions (e.g., in a cylindrical coordinate space, $\theta_1 = 0$ and $\theta_2 = \pi/2$), using a vertical 'y' axis normalized to the outermost extent of the beam in either of the two spatial directions. The short-dashed (- -) line describes the average beam energy, superimposed on the axes in the interest of demonstrating the relative position of the deceleration element (e.g., deceleration element 935 of FIG. 9, deceleration element 1035 of FIG. 10, deceleration element 1135 of FIG. 11, deceleration element 1235 of FIG. 12) to other optical elements acting on the beam. The various optical elements are illustrated as patterned regions of the plot, including a deceleration element 1305, a multipole objective 1310, and a multipole condenser 1315.

FIG. 13A is a ray diagram of a charged particle beam system including a deceleration element 1305 disposed before a multipole objective 1310, in accordance with embodiments of the present disclosure. The ray diagram of FIG. 13A illustrates example behavior of the ion beam 1300 (e.g., ion beam 1004 of FIG. 10, ion beam 1104 of FIG. 11, ion beam 1204 of FIG. 21) in a charged particle optical column (e.g., optical column 110 of FIG. 1, optical column 510 of FIG. 5, optical column 1010 of FIG. 10, etc.), in which the deceleration element 1305 is disposed between the multipole condenser 1315 and the multipole objective 1310, as described in more detail in reference to FIGs. 9-11.

The ion beam 1300 accelerates in the multipole condenser 1315, with the average beam energy increasing to a relatively higher energy at about a position of about $Z = -340$ units on the lateral x-axis. In the example of FIG. 13A, the multipole condenser applies a spatially symmetric force on the beam 1300, with one or more optics 1320 disposed along the axis, at a position of about $Z = -280$ on the lateral x-axis and applying an asymmetric force to expand and/or converge the beam in one spatial dimension relative to an orthogonal dimension. The resulting bifurcation of the rays indicate an asymmetric beam cross-section from a position of about $Z = -275$ to about $Z = -15$ on the lateral x-axis. The optic 1320 can be another multipole condenser, another electromagnetic lens or optical element, an aberration correction optic, or the like.

As described in reference to FIG. 9, the beam energy is maintained between the multipole condenser 1315 and the deceleration element 1305. The relatively elevated beam energy improves the performance of aberration correction optics, as described in reference to FIGs. 1-8, to correct chromatic and/or spherical aberrations in the beam 1300, that are disposed on the axis between the optic(s) 1320 and the deceleration element 1305.

FIG. 13B is a ray diagram of an aberration correction system including the deceleration element 1305 disposed after the multipole objective 13150, in accordance with embodiments of the present disclosure. The ray diagram of FIG. 13B illustrates example behavior of the ion beam 1300 in a charged particle optical column, in which the deceleration element 1305 is disposed between the multipole objective 1310 and a final crossover point at $Z = 0$, as described in more detail in reference to FIG. 12. The multipole objective 1310 is configured to act on the beam 1300 at substantially the same energy as the other optics in the column, such that at least a portion of the multipole objective 1310 is operably coupled with the acceleration system (e.g., acceleration system 1205 of FIG. 12), such as being disposed within a physical conducting element and/or coupled with bias circuitry configured to shield the beam 1300 from ground potential between about $Z = -50$ and $Z = -15$. Advantageously, the multipole objective 1305 can be calibrated for a narrower energy spread in the beam 1300, such that the objective lens assembly can occupy relatively less space in the column (e.g., corresponding to about one-half to two-thirds of the lateral size of the corresponding objective lens assembly in FIG. 13A).

FIG. 13C is a ray diagram of an aberration correction system including a deceleration element disposed after a chromatic aberration ($C_c$) corrector optic and before a multipole objective, in accordance with embodiments of the present disclosure. The ray diagram of FIG. 13C illustrates example behavior of the ion beam 1300 in a charged particle optical column, in which the deceleration element 1305 is disposed between a curved-axis Cc corrector optic 1325 (e.g., optic 300 of FIG. 3) and the multipole objective 1310, as described in more detail in reference to FIGs. 9-11. To that end, the multipole objective 1310 is configured to act on the beam 1300 at a relatively low energy, compared to the relatively high energy at which the Cc corrector optic 1325 acts on the beam 1300, after the beam 1300 exits the acceleration system (e.g., acceleration system 1005 of FIG. 10). In FIG. 13C, the curved segment of the axis corresponds to the positions from about $Z = -300$ to about $Z = -240$ on the lateral x-axis, which has been linearized and projected onto the lateral x-axis to focus description on the energy of the beam 1300 and the relative position of the components of the ion beam optical column.

In the system of FIG. 13C, the deceleration element 1305 can be or include an electromagnetic lens, such as a charged particle transfer lens. In contrast to the diagrams in FIGs. 13A-13B, the deceleration element 1305 in FIG. 13C applies an asymmetric force to the beam 1300 and expands the beam 1300 in one direction more than in the orthogonal direction. The resulting divergence of the beam at about $Z = -235$ increases until the beam 1300 enters the multipole objective 1310 at about $Z = -40$.

*General Considerations*

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

As used herein, the term "substantially" means the listed value and/or property and any value and/or property that is at least 75% of the listed value and/or property. Equivalently, the term "substantially" means the listed value and/or property and any value and/or property that differs from the listed value and/or property by at most 25%. For example, "substantially equal" refers to quantities that are fully equal, as well as to quantities that differ from one another by up to 25%.

The systems, apparatus, and methods described herein should not be construed as limiting in any way. Instead, the present disclosure is directed toward all novel and non-obvious features and aspects of the various disclosed examples, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

In various examples described herein, a module (e.g., a component) can be "programmed" to perform certain operations or provide certain functionality, indicating that computer-executable instructions for the module can be executed to perform such operations, cause such operations to be performed, or to otherwise provide such functionality. Although functionality described with respect to a software component, module, or engine can be carried out as a discrete software unit (e.g., program, function, class method), it need not be implemented as a discrete unit. That is, the functionality can be incorporated into a larger or more general-purpose program, such as one or more lines of code in a larger or general-purpose program.

Having described and illustrated the principles of the disclosed technology with reference to the illustrated examples, it will be recognized that the illustrated examples can be modified in arrangement and detail without departing from such principles. For instance, elements of examples performed in software may be implemented in hardware and vice-versa. Also, the technologies from any example can be combined with the technologies described in any one or more of the other examples. It will be appreciated that procedures and functions such as those described with reference to the illustrated examples can be implemented in a single hardware or software module, or separate modules can be provided. The particular arrangements above are provided for convenient illustration, and other arrangements can be used. Embodiments of the invention are set out in the following numbered clauses:

Clause 13. A charged particle beam system, comprising: a source of ions, configured to generate a beam of ions; a sample holder, defining a sample position; and an ion-optical column, coupled with the source of ions and configured to receive the beam of ions from the source of ions and direct the beam of ions toward the sample position, the ion-optical column comprising: an aberration correction system, disposed on an axis and comprising: a multipole lens comprising a plurality of multipole elements; and a deceleration element, disposed on the axis between at least a portion of the aberration correction system and the sample position.

Clause 14. The charged particle beam system of clause 13, wherein the multipole lens comprises a multipole objective, and wherein the multipole objective includes: at least three quadrupole-generating elements; and at least three octupole-generating elements, wherein the octupole-generating elements of the multipole objective are configured to at least partially correct a spherical aberration of the charged particle beam.

Clause 15. The charged particle beam system of clause 13, wherein the deceleration element comprises a plurality of electrodes, mutually isolated and disposed on the axis.

Clause 16. The charged particle beam system of clause 15, wherein the electrodes are annular, substantially centered about the axis, and mechanically coupled via insulating material.

Clause 17. The charged particle beam system of clause 13, further comprising an objective lens assembly, and wherein the deceleration element substantially overlaps with a position on the axis of a first element of the objective lens assembly.

Clause 18. The column of clause 13, further comprising bias circuitry, wherein at least a portion of the aberration correction system is electrically coupled with the bias circuitry and configured to operate at a bias voltage supplied by the bias circuitry.

Clause 19. The charged particle beam system of clause 18, further comprising a conducting element disposed about the axis and terminating at a first end proximal to the deceleration element, the conducting element being operably coupled with the bias circuitry.

Clause 20. The charged particle beam system of clause 13, wherein the deceleration element comprises an ion-transfer lens.

**Claims**

1.  An ion-optical column, comprising:

    an aberration correction system, disposed on an axis and comprising:
    a multipole lens a plurality of multipole elements;
    and
    a deceleration element, disposed on the axis between at least a portion of the aberration correction system and a sample position.

2.  The column of claim 1, wherein the multipole lens comprises a multipole objective, including:

    at least three quadrupole-generating elements; and
    at least three octupole-generating elements, wherein the octupole-generating elements of the multipole objective are configured to at least partially correct a spherical aberration of the charged particle beam.

3.  The column of claim 2, wherein the multipole objective comprises:

    a first objective multipole element configured to generate a first objective multipole field comprising a first objective quadrupole field component and a first objective octupole field component;
    a second objective multipole element positioned downstream of the first objective multipole element and configured to generate a second objective multipole field comprising a second objective octupole field component; and
    a third objective multipole element positioned downstream of the second objective multipole element and configured to generate a third objective multipole field comprising a third objective quadrupole field component and a third objective octupole field component.

4.  The column of claim 3, further comprising a fourth objective multipole element positioned downstream of the third objective multipole element and configured to generate fourth objective multipole field comprising a fourth objective quadrupole field component, wherein the fourth objective multipole element comprises eight electrodes.

5.  The column of claim 1, wherein the deceleration element comprises a plurality of electrodes, mutually isolated and disposed on the axis.

6.  The column of claim 5, wherein the electrodes are annular, substantially centered about the axis, and mechanically coupled via insulating material.

7.  The column of claim 1, further comprising an objective lens assembly, disposed on the axis, wherein the deceleration element substantially overlaps with a position on the axis of a first element of the objective lens assembly.

8.  The column of claim 1, further comprising bias circuitry, wherein at least a portion of the aberration correction system is electrically coupled with the bias circuitry and configured to operate at a bias voltage supplied by the bias circuitry.

9.  The column of claim 8, further comprising a conducting element disposed about the axis and terminating at a first end proximal to the deceleration element, the conducting element being operably coupled with the bias circuitry.

10. The column of claim 9, wherein the conducting element defines an inner volume, and wherein at least the portion of the aberration correction system is disposed in the inner volume.

11. The column of claim 1, wherein the aberration correction system further comprises a chromatic aberration corrector disposed on the axis.

12. The column of claim 11, wherein the chromatic aberration corrector comprises:

    a plurality of electrostatic elements configured to deflect an incident charged particle beam along an $\alpha$-shaped path, wherein the plurality of electrostatic elements comprises a plurality of electrostatic multipole elements configured to at least partially correct an axial chromatic aberration of the charged particle beam; and
    a deflector assembly comprising a corrector electrostatic prism and the plurality of electrostatic multipole elements, wherein the deflector assembly is configured to deflect the charged particle beam along a deflector optical axis, wherein:

the corrector electrostatic prism comprises a corrector prism body with a first corrector prism electrode and a second corrector prism electrode positioned radially exteriorly of the first corrector prism electrode, the first corrector prism electrode and the second corrector prism electrode define an electrode gap therebetween, and
the deflector assembly is configured to at least partially correct an axial chromatic aberration in the charged particle beam with two or more hexapole fields generated within the corrector electrostatic prism.

13. A charged particle beam system, comprising:

a source of ions, configured to generate a beam of ions;
a sample holder, defining a sample position; and
an ion-optical column in accordance with any of claim 1-12, the ion-optical column being coupled with the source of ions and configured to receive the beam of ions from the source of ions and direct the beam of ions toward the sample position.

14. The charged particle beam system of claim 13 when dependent upon claim 1, wherein the deceleration element comprises an ion-transfer lens.

**FIG. 1**

**FIG. 2**

FIG. 3

FIG. 4

**FIG. 5**

FIG. 6

FIG. 7

FIG. 8

**FIG. 9**

**FIG. 10**

FIG. 11

**FIG. 12**

**FIG. 13A**

**FIG. 13B**

**FIG. 13C**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040051985

**Non-patent literature cited in the description**

- **H. ROSE** ; **A. NEJATI** ; **H. MÜLLER**. Magnetic Cc/Cs-corrector compensating for the chromatic aberration and the spherical aberration of electron lenses. *Ultramicroscopy*, 2019, vol. 203, 139-144